# EUROPEAN PATENT APPLICATION

(11) **EP 2 110 866 A1**
(43) Date of publication of application: **21.10.2009**
(21) Application number: 08711033.4
(22) Date of filing: 08.02.2008
(51) Int. Cl.: H01L 33/00

(54) **LED PACKAGE AND STRUCTURE FOR MOUNTING THREE-DIMENSIONAL CIRCUIT COMPONENT**

(30) Priority: 15.02.2007 JP 2007034324; 21.02.2007 JP 2007040673; 24.04.2007 JP 2007114739
(71) Applicant: Panasonic Electric Works Co., Ltd, Kadoma-shi Osaka 571-8686 (JP)
(72) Inventor: The designation of the inventor has not yet been filed
(74) Representative: Appelt, Christian W.
(86) International application number: PCT/JP2008/052154
(87) International publication number: WO 2008/099784

(57) **Abstract**

An LED package includes: a molded interconnect device 12 that has an LED chip 11 mounted thereon, and is mounted on a mounting board 20 electrically connected to the LED chip 11; and a plurality of elastic bodies 17 mounted on the mounting board 20 while interposing solder 21 therebetween. The plurality of elastic bodies 17 hold a position of the molded interconnect device 12 with respect to the mounting board 20 by elastic forces given to an inner surface side of the molded interconnect device 12 from a plurality of outer side surfaces thereof opposite to each other.

## Description

### TECHNICAL FIELD

The present invention relates to an LED package in which a light emitting diode (hereinafter, referred to as an LED) chip is mounted on a package body, and to an attachment structure of a molded circuit component.

### BACKGROUND ART

Heretofore, there has been proposed an LED package, in which an LED chip is mounted on a predetermined package body, and the package body having the LED chip mounted thereon is mounted on a mounting board such as a printed circuit board. Such an LED package has a problem that, when there is a difference in amount of solder between electrodes at the time of mounting the LED chip on the mounting board by the solder, a so-called Manhattan phenomenon occurs, in which one of the electrodes is raised owing to a difference in surface tension when the solder is molten, a contraction stress when the solder is solidified, and the like. In order to solve this Manhattan phenomenon, a technology described in Japanese Patent Laid-Open Publication No. 2000-216440 (hereinafter, referred to as Patent Literature 1) has been proposed.

In this Patent Literature 1, a light emitting diode is disclosed, which includes a plate-like board in which one of surfaces is used as an element attachment surface and is provided with an electrode for an element and the other surface is used as a terminal attachment surface and is provided with an electrode for a terminal. In particular, in this light emitting diode, a through-hole electrode that reaches the other surface of the plate-like board from the one surface thereof is provided, and the electrode for the element and the electrode for the terminal are electrically connected to each other by the through-hole electrode, whereby a stress that raises one of end portions of the plate-like board is eliminated from occurring in the plate-like board even if the amount of solder becomes nonuniform, and a conduction failure can be thereby prevented.

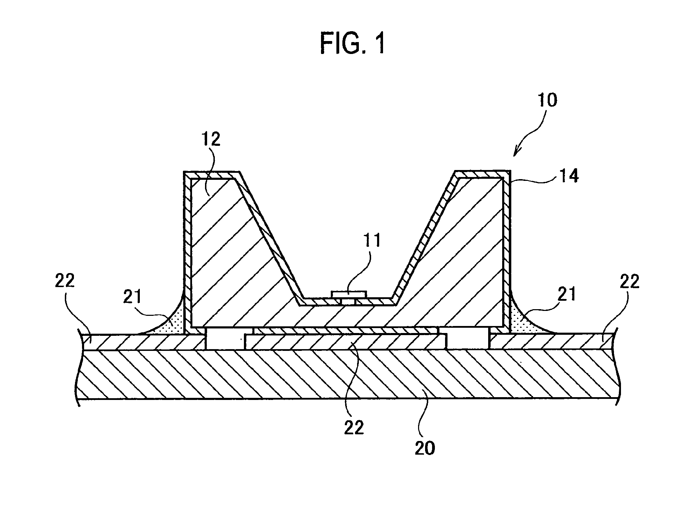

Moreover, as a conventional LED package, an LED package of which cross-sectional view is shown in FIG. 1 is known. This LED package is mounted on a mounting board 20, on which predetermined circuit patterns 22 are formed, while interposing solder 21 therebetween. A package body 10 includes a body portion 12 formed, for example, of a ceramic sintered body. The body portion 12 is composed so that a conical hollow in which a head is cut off can be formed on a center portion thereof, and that an LED chip 11 can be mounted on a bottom surface thereof. The bottom surface of the conical hollow in which the head is cut off is used as an LED chip mounting portion 13 that mounts the LED chip 11 thereon.

Incidentally, in the case of mounting the LED package on the mounting board by the solder, then in the LED package, a linear expansion coefficient of the mounting board is larger than a linear expansion coefficient of the LED package. In the case where a stress is concentrated on a connection portion of the LED package and such a wiring pattern on the mounting board owing to a thermal hysteresis, there has been a problem that the solder is sometimes broken at the time of a heat cycle test or the like owing to such a phenomenon of the stress concentration, causing the conduction failure. This problem is caused by that the package body is formed of the ceramic material. This problem occurs not only at the time when the LED package is used but also at the time when the LED package is mounted by the solder.

Specifically, in the LED package as shown in FIG. 1, when heat generated from the LED chip 11 transmits to the body portion 12, the resin-made mounting board 20 and a heat radiation plate (not shown), it is possible that the solder 21 as the connection portion may be broken owing to differences in linear expansion coefficient among the body portion 12, the mounting board 20 and the heat radiation plate.

In this connection, in order to solve such a problem, an LED package has also been proposed, to which a molded circuit component is attached by using a socket having a contact spring, and in which the molded circuit component and the socket are electrically connected to each other.

However, at the time of attaching the plate-like board to the socket in the case of using the plate-like board described in Patent Literature 1, a width of the socket is widened when the contact spring is brought into contact with a side surface portion of the plate-like board, and the socket is thickened when the contact spring is brought into contact with an upper surface portion or lower surface portion of the plate-like board.

As described above, in the above-described conventional technology, it has been difficult to miniaturize an attachment structure of the molded circuit component.

In this connection, the present invention has been created in order to solve such problems as described above. It is an object of the present invention to provide an LED package that relieves the stress generated owing to the difference thereof from the mounting board in linear expansion coefficient, thereby prevents the breakage of the solder, and can prevent the conduction failure.

It is another object of the present invention to obtain an attachment structure of the molded circuit component, which can suppress the conduction failure, and can achieve miniaturization thereof.

### DISCLOSURE OF THE INVENTION

In order to solve the above-mentioned problems, an LED package according to the present invention includes: a molded interconnect device that has an LED chip mounted thereon, and is mounted on a mounting board electrically connected to the LED chip; and a plurality of elastic bodies mounted on the mounting board while interposing solder therebetween.

In this LED package, the plurality of elastic bodies may hold a position of the molded interconnect device with respect to the mounting board by elastic forces given to an inner surface side of the molded interconnect device from a plurality of outer side surfaces thereof opposite to each other.

Moreover, in this LED package, the plurality of elastic bodies may hold the position of the molded interconnect device with respect to the mounting board by elastic force given from an upper surface of the molded interconnect device to a lower surface thereof.

Furthermore, in this LED package, in the molded interconnect device, recessed portions may be formed on the plurality of outer side surfaces thereof opposite to each other, and the plurality of elastic bodies may hold the position of the molded interconnect device with respect to the mounting board by elastic forces given to the inner surface side of the molded interconnect device from the recessed portions thereof.

Still further, in this LED package, in the molded interconnect device, notched recessed portions may be formed on lower ends of the plurality of outer side surfaces thereof opposite to each other, and the plurality of elastic bodies may be housed in insides of the recessed portions formed on the molded interconnect device, the insides being also insides of an outer shape of the molded interconnect device, and may hold the position of the molded interconnect device with respect to the mounting board by elastic forces given to the inner surface side of the molded interconnect device from the recessed portions thereof.

Moreover, in order to achieve the above-mentioned object, an LED package according to the present invention includes: a molded interconnect device that has an LED chip mounted thereon, and is mounted on a mounting board electrically connected to the LED chip; and a plurality of circuit patterns which are connected to the LED chip and a circuit pattern on the mounting board while interposing solder therebetween, and are formed along an outer wall of the molded interconnect device.

In order to solve the above-mentioned problems, in the LED package as described above, the plurality of circuit patterns are individually formed on adjacent side surfaces among a plurality of side surfaces of the molded interconnect device. Moreover, in order to solve the above-mentioned problems, in the LED package, the plurality of circuit patterns may be individually formed on a single surface among the plurality of side surfaces of the molded interconnect device.

Moreover, in order to achieve the above-mentioned object, the present invention is an attachment structure of a molded circuit component, including: a molded circuit component, on a surface of which circuit patterns electrically connecting an electronic component thereto are formed, the molded circuit component having the electronic component mounted thereon; and a socket having a frame portion that houses the molded circuit component therein, and a contact spring portion that holds the molded circuit component, wherein, in the molded circuit component, notched recessed portions formed by cutting off side portions of the molded circuit component are provided, and terminal portions, each of which is a part of the circuit pattern, are provided on inner surfaces of the notched recessed portions, and the contact spring portion includes first contact springs which contact the terminal portions, and hold the molded circuit component by pressing the inner surfaces of the notched recessed portions.

Moreover, in this attachment structure of a molded circuit component, the contact spring portion may include second contact springs which hold the molded circuit component.

Furthermore, in this attachment structure of a molded circuit component, the second contact springs and the frame portion may be molded integrally with each other.

Moreover, in this attachment structure of a molded circuit component, recessed portions may be formed on at least a part of the molded circuit component, and the circuit patterns may be formed in the recessed portions.

Moreover, in this attachment structure of a molded circuit component, the first contact springs may include bent portions which abut against the terminal portions, and the terminal portions may include notch portions, and may bring the bent portions into contact with the notch portions at two spots.

Furthermore, in this attachment structure of a molded circuit component, the socket may include protruding portions which support the molded circuit component.

Moreover, in this attachment structure of a molded circuit component, a lower surface portion of the molded circuit component may be allowed to abut against a heat radiation plate.

Moreover, in this attachment structure of a molded circuit component, a holding fixture that holds the socket may be provided under the socket, and the lower surface portion of the molded circuit component may be allowed to abut against the heat radiation plate while interposing the holding fixture therebetween.

Moreover, in this attachment structure of a molded circuit component, protruding portions may be formed on the lower surface portion of the molded circuit component, insertion holes may be provided in the holding fixture, and the protruding portions may be inserted through the insertion holes.

Furthermore, in this attachment structure of a molded circuit component, the holding fixture may include attachment portions to the heat radiation plate.

Still further, in this attachment structure of a molded circuit component, protruding and recessed portions which fit to each other may be provided on the molded circuit component and the heat radiation plate, respectively.

### BRIEF DESCRIPTION OF THE DRAWINGS

FIG. 1 is a cross-sectional view showing a conventional LED package.
FIG. 2 is a perspective view showing an exterior configuration of a package body in an LED package shown as a first embodiment of the present invention.
FIG. 3 is a perspective view showing an exterior configuration of a package body in the LED package shown as the first embodiment of the present invention, showing a configuration of a package body on which a metal film having high reflectivity is formed.
FIG. 4 is a cross-sectional view of the LED package shown as the first embodiment of the present invention.
FIGS. 5 (a) to 5 (d) are views for explaining the respective processes of a thin film outline removing method for manufacturing the LED package.
FIGS. 6(a) to 6(e) are views for explaining states of manufacturing the LED package shown as the first embodiment of the present invention.
FIGS. 7(a) and 7(b) are perspective views showing an elastic body in the LED package shown as the first embodiment of the present invention.
FIG. 8 is a perspective view showing another elastic body in the LED package shown as the first embodiment of the present invention.
FIG. 9 is a cross-sectional view of an LED package shown as another embodiment of the present invention.
FIG. 10 is a cross-sectional view of an LED package shown as another embodiment of the present invention.
FIG. 11 is a cross-sectional view of an LED package shown as another embodiment of the present invention.
FIG. 12 is a cross-sectional view of an LED package shown as another embodiment of the present invention.
FIG. 13 is a perspective view showing an exterior configuration of a package body in an LED package shown as a second embodiment of the present invention.
FIG. 14 is a perspective view showing another exterior configuration of the package body in the LED package shown as the second embodiment of the present invention.
FIGS. 15(a) to 15(d) are views for explaining the respective processes of a thin film outline removing method for manufacturing the LED package.
FIGS. 16(a) to 16(d) are views for explaining states of manufacturing the LED package shown as the second embodiment of the present invention.
FIG. 17 is a perspective view of an attachment structure of a molded circuit component according to a third embodiment of the present invention.
FIG. 18 is an exploded perspective view of the attachment structure of the molded circuit component according to the third embodiment of the present invention.
FIG. 19 is a plan view of the attachment structure of the molded circuit component according to the third embodiment of the present invention.
FIG. 20 is a cross-sectional view along a line A-A of FIG. 19.
FIG. 21 is a cross-sectional view along a line B-B of FIG. 19.
FIG. 22 is an exploded perspective view of an attachment structure of a molded circuit component according to a modification example of the third embodiment of the present invention.
FIG. 23 is a perspective view of an attachment structure of a molded circuit component according to a fourth embodiment of the present invention.
FIG. 24 is an exploded perspective view of the attachment structure of the molded circuit component according to the fourth embodiment of the present invention.
FIG. 25 is a plan view of the attachment structure of the molded circuit component according to the fourth embodiment of the present invention.
FIG. 26 is a cross-sectional view along a line C-C of FIG. 25.
FIG. 27 is a cross-sectional view along a line D-D of FIG. 25.
FIG. 28 is a perspective view of an attachment structure of a molded circuit component according to a fifth embodiment of the present invention.
FIG. 29 is an exploded perspective view of the attachment structure of the molded circuit component according to the fifth embodiment of the present invention.
FIG. 30 is a plan view of the attachment structure of the molded circuit component according to the fifth embodiment of the present invention.
FIG. 31 is a cross-sectional view along a line E-E of FIG. 30.
FIG. 32 is a cross-sectional view along a line F-F of FIG. 30.

### BEST MODE FOR CARRYING OUT THE INVENTION

A description will be made below of embodiments of the present invention with reference to the drawings.

### (First Embodiment)

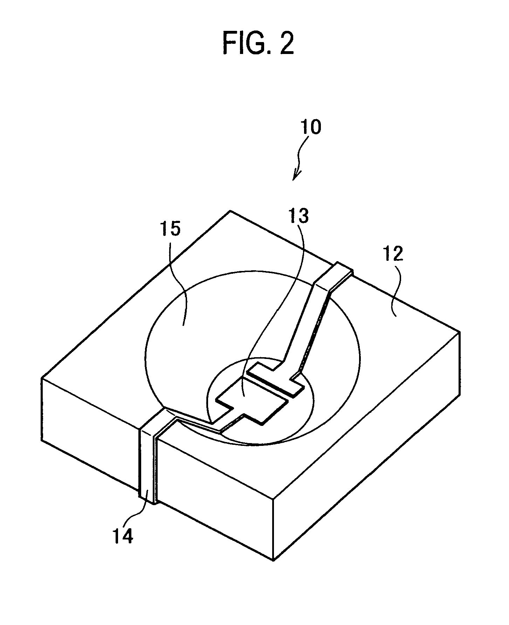

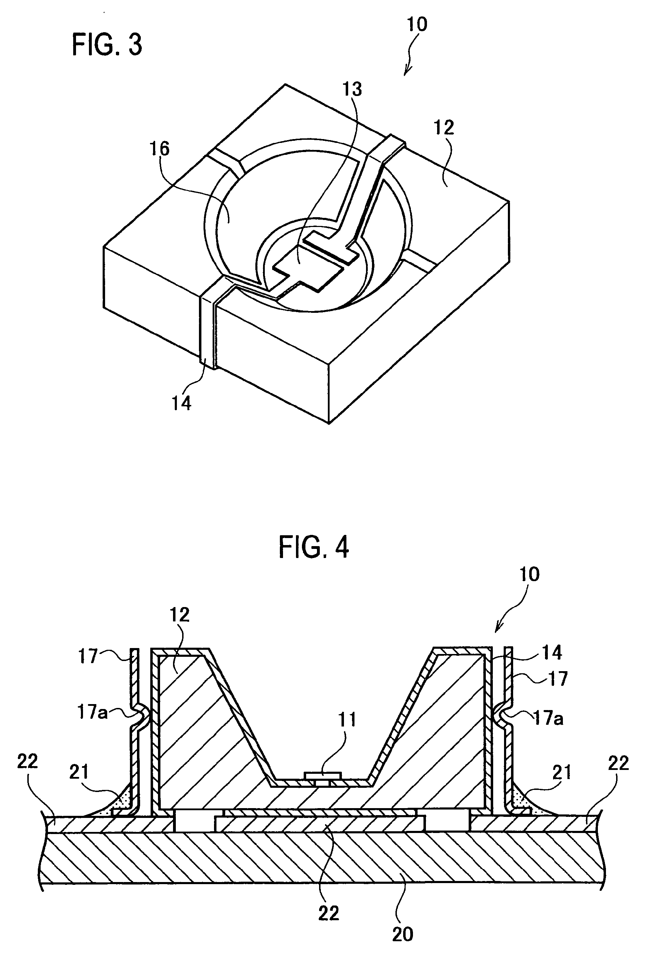

FIG. 2 and FIG. 3 are perspective views showing exterior configurations of package bodies 10, each of which mounts an LED chip thereon, and FIG. 4 is a cross-sectional view showing a state of mounting, on a mounting board 20, an LED package in which the LED chip 11 is mounted on the package body 10.

The package body 10 includes a body portion 12 formed, for example, of a ceramic sintered body. As a ceramic material, used are alumina, aluminum nitride, silicon nitride, and the like. As a manufacturing method of the ceramic sintered body, used are injection molding, compression molding (press molding), cast molding, and the like, and any of these methods may be used in manufacturing the package body 10. The body portion 12 is composed so that a conical hollow in which a head is cut off can be formed on a center portion thereof, and that the LED chip 11 can be mounted on a bottom surface thereof.

The bottom surface of the conical hollow in which the head is cut off is used as an LED chip mounting portion 13 that mounts the LED chip 11 thereon. Hence, the package body 10 functions as a molded interconnect device (MID) in which circuit patterns (wiring) 14 are provided from the LED chip mounting portion 13 to side surfaces of the body portion 12. Moreover, a conical surface of the conical hollow in which the head is cut off functions as a reflecting plate 15 that reflects light radiated from the LED chip 11. By forming the reflecting plate 15 into such a conical surface, the LED package can realize high reliability and high light extraction efficiency. Note that, in the package body 10, for example as shown in FIG. 3, a metal film 16 having high reflectivity may be formed on a portion of the reflecting plate 15. In such a way, in the LED package, higher reliability and higher light extraction efficiency can be realized.

In the LED package as described above, such a molded circuit board in which the LED chip mounting portion 13 and the reflecting plate 15 are integrated together can be formed easily by a thin film outline removing method. This thin film outline removing method is composed of the following processes.

First, in the thin film outline removing method, a heating treatment process is executed, the sintered body is subjected to heat treatment under conditions where a temperature is 1000°C and a holding time is one hour, and a surface of the sintered body is cleaned.

Subsequently, in the thin film outline removing method, a conductive thin film forming process is executed. This process is a process for forming a conductive thin film on a surface of a board material by a physical evaporation method using a vacuum evaporation device, a DC magnetron sputtering device and the like, by a wet method such as electroless plating, and by the like. Specifically, the board material is set in a chamber of a plasma processing device, an inside of the chamber is decompressed to approximately 10⁻⁴ Pa, and thereafter, this specimen is preheated at a temperature of 100 to 200°C for three minutes. Thereafter, gas of nitrogen, argon or the like is flown into the chamber, and a pressure of the gas in the chamber is controlled to approximately 10 Pa. Then, a high frequency voltage (RF: 13.56 MHz) of which power is 100 to 1000W is applied between electrodes for 10 to 300 seconds, whereby plasma processing is performed. Subsequently, a pressure in the chamber is controlled to 10⁻⁴ Pa or less, and argon gas is introduced into the chamber in this state so that a pressure thereof can become approximately 0.6 Pa, and thereafter, a direct current voltage of 300 to 600V is further applied between the electrodes, whereby a metal target is bombarded, and a conductive thin film of which film thickness is in a range from 100 to 1000 nm is formed on a surface of the specimen. Note that copper, nickel, chromium, titanium and the like are used as the conductive material.

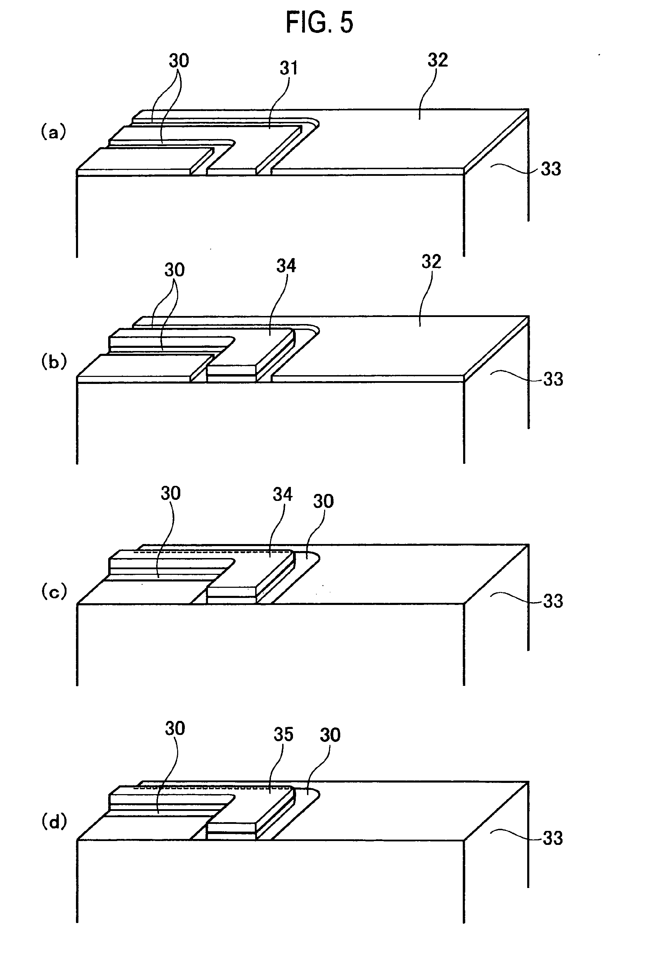

Subsequently, in the thin film outline removing method, a circuit pattern forming process is executed, and for example as shown in FIG. 5(a), a laser is scanned along an outline of the circuit pattern by using a third harmonic generation (THG-YAG laser) of a YAG laser in the atmosphere, and a thin film removal portion 30 is formed, which is obtained by removing only the thin film of an outline portion of a circuit pattern 31 from a conductive film 32 formed on an alumina substrate 33. Subsequently, in the thin film outline removing method, a plating process is executed, and for example as shown in FIG. 5(b), copper plating 34 is formed only on an electric circuit portion on the surface of the sintered body by electrolytic plating, and is thereby thickened, and a copper film of which thickness is 5 to 15 µm is formed. Thereafter, for example as shown in FIG. 5(c), the entire surface of the sintered body is etched, whereby the conductive thin film 32 remaining on a non-electric circuit portion is removed completely by etching. At this time, the copper plating 34 is formed thicker than the conductive thin film 32, and accordingly, remains. Then, for example as shown in FIG. 5(d), nickel plating or gold plating 35 is formed on the electric circuit portion by electric plating.

The LED package can be easily formed by the thin film outline removing method as described above. Note that, in the case of manufacturing the LED package shown in FIG. 3 by the thin film outline removing method, after similarly performing the processes up to the copper plating, the etching and the nickel plating, which are described above, the gold plating just needs to be formed on the electric circuit portion by supplying electric power only to the electric circuit portion, and for example, silver plating just needs to be formed on the reflecting plate 15 by supplying the electric power only to the reflecting plate 15.

As shown in FIG. 4, the LED package formed as described above is mounted on the mounting board 20 on which the predetermined circuit pattern 22 is formed while interposing the solder 21 and a plurality of elastic bodies 17 therebetween. In the elastic bodies 17, spring portions 17a are formed on contact portions thereof with the body portion 12. The elastic bodies 17 generate elastic forces given to an inner surface side of the body portion 12 from a plurality of outer side surfaces thereof opposite to each other. In such a way, the plurality of elastic bodies 17 sandwich the body portion 12 therebetween by being fitted into recessed portions 12a, and hold a position of the body portion 12 with respect to the mounting board 20. Moreover, the elastic bodies 17 relieve a stress generated on an interface between the package body 10 and the mounting board 20. Specifically, in the case where there is a difference in linear expansion coefficient between the body portion 12 and the mounting board 20, the elastic bodies 17 relieve a positional shift of the body portion 12 with respect to the mounting board 20.

In the LED package, the elastic bodies 17 are provided. In such a way, even if the stress is generated on the interface owing to the difference in linear expansion coefficient between the LED package and the mounting board 20 in the case where both thereof expand thermally by the heat generation of the LED chip 11, a deformation therebetween is absorbed by the elastic bodies 17, and a concentration of the stress is relieved. In such a way, an occurrence of a failure that causes breakage of the portion of the solder 21 can be reduced.

Moreover, besides preventing a crack of the solder 21 owing to such a structure as shown in FIG. 1, the LED package can bring advantages that the body portion 12 becomes less likely to fall off from the mounting board 20, that the body portion 12 is detachable from the mounting board 20, and the like.

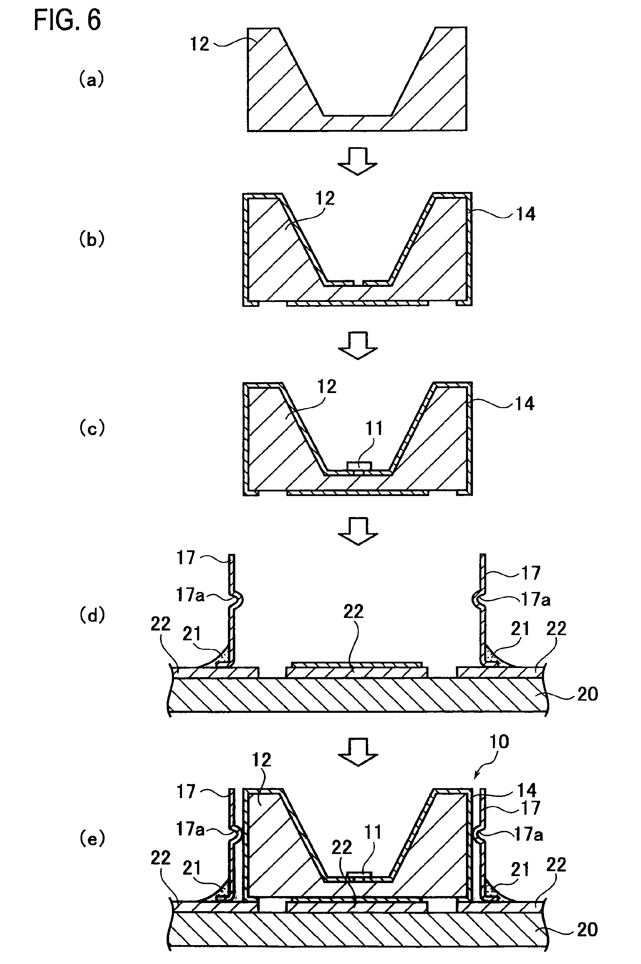

The LED package provided with the elastic bodies 17 as described above can be formed in the following manner. Specifically, in manufacturing the LED package, for example as shown in FIG. 6(a), the sintered body (body portion 12) is formed. Subsequently, in manufacturing the LED package, for example as shown in FIG. 6(b), circuit patterns 14 are formed on the surface of the sintered body by the above-mentioned thin film outline removing method, and as shown in FIG. 6(c), the LED chip 11 is mounted on the LED chip mounting portion 13. Thereafter, as shown in FIG. 6(d), two elastic bodies 17 are solder-mounted on the mounting board 20 so as to be brought into individual contact with the portions opposite to each other in the body portion 12, that is, with the circuit patterns 14 opposite to each other in FIG. 2. As shown in FIG. 6(e), the LED package formed as described above is positioned and mounted on the mounting board 20 so as to be located between the elastic bodies 17.

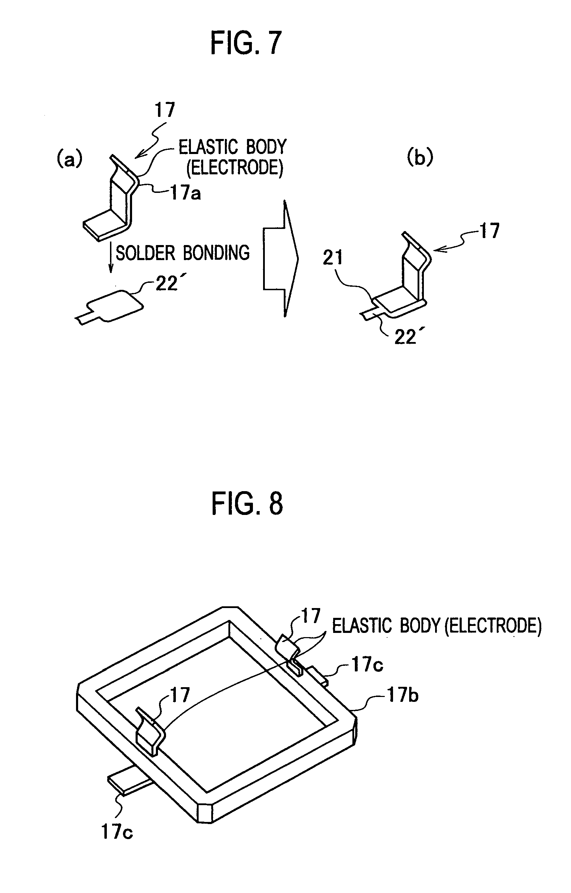

In the LED package manufactured as described above, in order to accurately position the body portion 12 on a predetermined position, as shown in FIG. 7(a), a shape of a circuit pattern 22' for fixing each of the elastic bodies 17 thereto by the solder 21 is formed into a pad shape of a pad portion. In short, the shape of the circuit pattern 22' is made substantially the same as a shape of a bottom surface of the elastic body 17. In such a way, when the solder 21 is attached onto the pad portion of the circuit pattern 22', and the bottom surface of the elastic body 17 is arranged on the pad portion of the circuit pattern 22' as shown in FIG. 7(b), the elastic body 17 and the pad portion of the circuit pattern 22' can be positionally aligned with each other by self-alignment of the solder 21. Specifically, even if an arranged position of the elastic body 17 is shifted, the bottom surface of the elastic body 17 can be fixed to a position onto which the solder 21 is attached. In such a way, the body portion 12 is positioned by the elastic bodies 17.

Moreover, in order to accurately position the body portion 12 on the predetermined position, as shown in FIG. 8, a molded body 17b including the elastic bodies 17 and mounting portions 17c may be mounted on the mounting board 20. The molded body 17b is formed into a frame shape, and has a dimension to allow the body portion 12 to be housed in an inside of such a frame. In this molded body 17b, the mounting portions 17c are arranged on the circuit pattern 22, and the mounting portions 17c concerned and the circuit pattern 22 are adhered onto each other by the solder 21. In the case where the molded body 17 having the frame shape as described above is adhered onto the circuit pattern 22 by the solder 21, the body portion 12 is arranged in the inside of the frame, and is positioned by the elastic forces of the elastic bodies 17.

Moreover, the LED package may also adopt a configuration in which a protrusion (not shown) is provided on a lower surface of the molded body 17b having the frame shape, a recessed portion that fits to the protrusion is provided on the mounting board 20, and the protrusion and the recessed portion are fitted to each other, whereby the body portion 12 is positioned to the mounting board 20.

Next, a description will be made of other LED packages to which the present invention is applied.

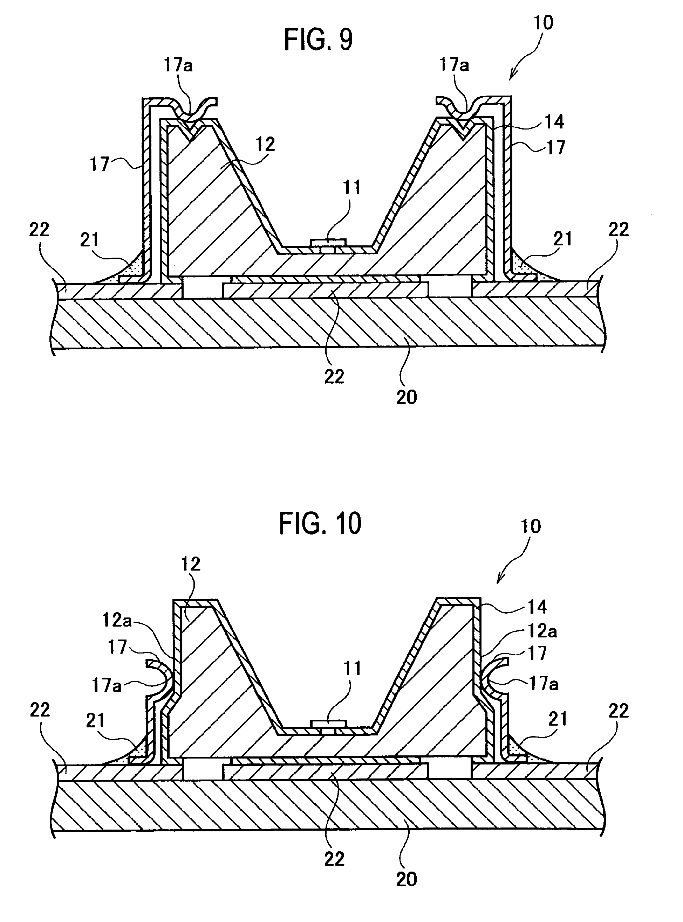

In the body portion 12 in an LED package shown in FIG. 9, the recessed portions 12a are formed on an upper portion thereof. The plurality of elastic bodies 17 are attached onto the mounting board 20 and the circuit pattern 22 by the solder 21 so that spring portions 17a having a protruding shape can be fitted into the recessed portions 12a. The LED package as described above gives the elastic forces from an upper surface of the body portion 12 to a lower surface thereof by the spring portions 17a of the plurality of elastic bodies 17 mounted on the mounting board 20 while interposing the solder 21 therebetween. The elastic forces are given substantially vertically from the spring portions 17a toward the recessed portions 12a. In such a way, the elastic bodies 17 hold a position of the body portion 12 concerned with respect to the mounting board 20.

In accordance with the LED package including the elastic bodies 17 as described above, in comparison with the case of giving the elastic forces from the side surfaces of the above-mentioned body portion 12 to the inside thereof, the body portion 12 can be positioned to the mounting board 20 with larger forces. In particular, the body portion 12 can be prevented from separating and falling down from the mounting board 20. Moreover, in accordance with this LED package, even if the stress is generated in the planar direction owing to the difference in linear expansion coefficient between the body portion 12 and the mounting board 20, the occurrence of the crack in the solder 21 can be prevented more since the body portion 12 is not pushed in such a direction where the stress is generated.

In an LED package shown in FIG. 10, the recessed portions 12a are formed on the plurality of outer side surfaces of the body portion 12, which are opposite to each other. By the spring portions 17a, the plurality of elastic bodies 17 give the elastic forces from the recessed portions 12a of the body portion 12 to the inner surface side thereof. In such a way, the position of the body portion 12 concerned with respect to the mounting board 20 is held. Note that the recessed portions 12a may be formed only on portions of the body portion 12, against which the spring portions 17a of the elastic bodies 17 abut.

In accordance with the LED package including the elastic bodies 17 as described above, the spring portions 17a of the elastic bodies 17 give the elastic forces to the recessed portions 12a of the body portion 12, and accordingly, the occurrence of the crack in the solder 21 can be prevented in a similar way to the above-mentioned LED package. Moreover, in accordance with this LED package, the body portion 12 can be surely prevented from falling off from the mounting board 20.

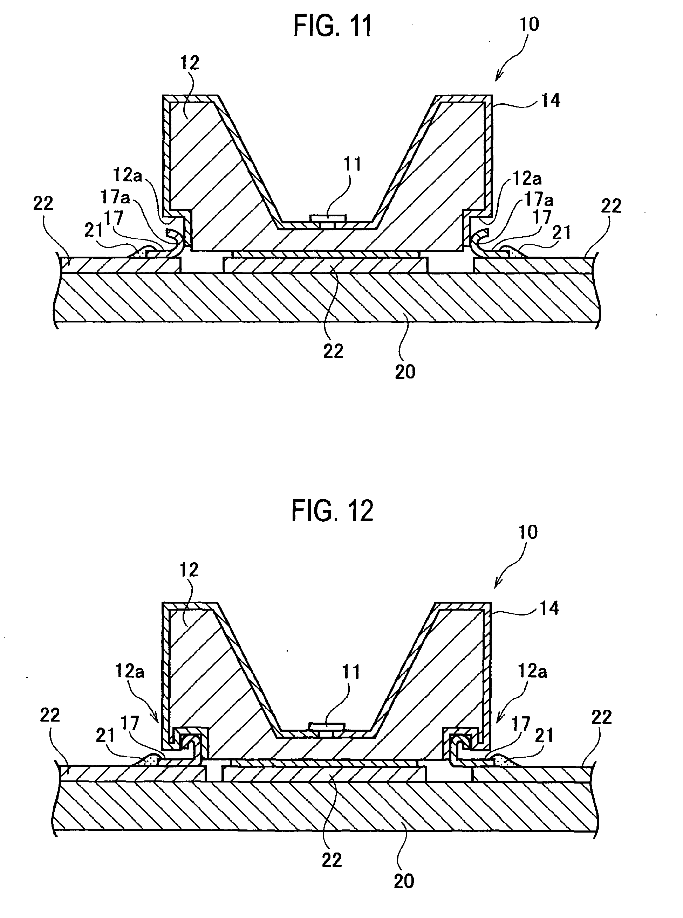

In an LED package shown in FIG. 11, on the body portion 12, notched recessed portions 12a are formed on lower ends of the plurality of outer side surfaces thereof opposite to each other. The plurality of elastic bodies 17 are arranged to be housed in insides of the recessed portions 12a formed on the body portion 12, which are also insides of an outer shape of the body portion 12 concerned. The elastic bodies 17 hold the position of the body portion 12 with respect to the mounting board 20 by the elastic forces given thereby from the recessed portions 12a of the body portion 12 to the inner surface side of the body portion 12 concerned. Moreover, another example of providing the recessed portions 12a on the lower ends of the body portion 12 may be, as shown in FIG. 12, an LED package that houses the spring portions of the elastic bodies 17 in the recessed portions 12a concerned.

In accordance with the LED package including the elastic bodies 17 as described above, the spring portions 17a of the elastic bodies 17 give the elastic forces to the recessed portions 12a of the body portion 12. Accordingly, the occurrence of the crack in the solder 21 can be prevented in a similar way to the above-mentioned LED package. Moreover, in accordance with the LED package, since the elastic bodies 17 are housed in the recessed portions 12a, the LED package itself can be miniaturized.

Note that the above-mentioned embodiment is merely an example of the present invention. Accordingly, the present invention is not limited to the above-mentioned embodiment, and it is a matter of course that it is possible to add various alterations to the embodiment according to needs within the scope without departing from the technical concept according to the present invention.

### (Second Embodiment)

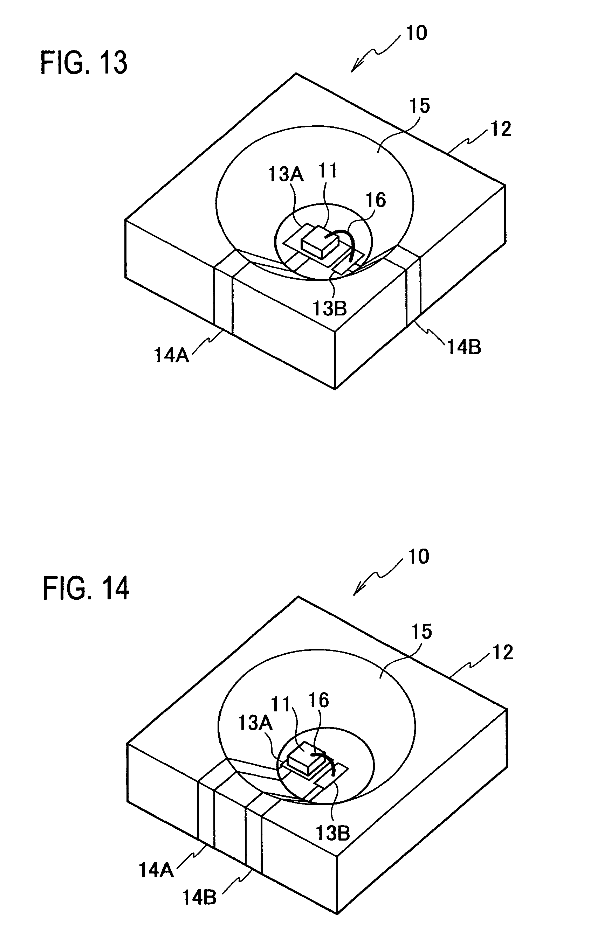

FIG. 13 and FIG. 14 show exterior configurations of package bodies 10, each of which mounts the LED chip 11 thereon.

Each of the package bodies 10 shown in FIG. 13 and FIG. 14 is **characterized in that** a circuit pattern 14a to which a positive terminal of the LED chip 11 is connected and a circuit pattern 14B to which a negative terminal of the LED chip 11 is connected are arranged close to each other. The package body 10 shown in FIG. 13 shows a state where the circuit patterns 14A and 14B are arranged on two adjacent side surfaces among four side surfaces of the body portion 12 having a solid shape. The package body 10 shown in FIG. 14 shows a state where the circuit patterns 14A and 14B are arranged on a single side surface among the four side surfaces of the body portion 12 having the solid shape.

As described above, even if a plurality of the circuit patterns connected to the LED chip 11 are present, the plurality of circuit patterns are arranged close to each other. The circuit patterns 14A and 14B and the mounting board are fixed to each other by being soldered, and the package body 10 is fixed to the mounting board while making others than these free. In such a way, an absolute expansion amount of the body portion 12 between the soldered circuit patterns 14A and 14B when the LED chip 11 generates heat is reduced, and the crack is prevented from occurring in the solder.

The package body includes the body portion 12 formed, for example, of a ceramic sintered body. As a ceramic material, used are alumina, aluminum nitride, silicon nitride, and the like. As a manufacturing method of the ceramic sintered body, used are injection molding, compression molding (press molding), cast molding, and the like, and any of these methods may be used in manufacturing the package body 10. The body portion 12 is composed so that a conical hollow in which a head is cut off can be formed on a center portion thereof, and that the LED chip 11 can be mounted on a bottom surface thereof.

The bottom surface of the conical hollow in which the head is cut off is used as a mounting surface of the LED chip 11, which mounts the LED chip 11 thereon. On this mounting surface of the LED chip 11, formed are: an LED chip mounting portion 13A that composes a part of the circuit pattern 14A; and an LED chip mounting portion 13B that composes a part of the circuit pattern 14B. The LED chip 11 is attached to the LED chip mounting portion 13A. A wire 16 connected to the LED chip 11 is soldered to the LED chip mounting portion 13B. To the LED chip mounting portion 13A, a drive current of the LED chip 11 is supplied through the circuit pattern 14A. To the LED chip mounting portion 13B, a grounding terminal (not shown) is connected through the circuit pattern 14B. In such a way, the package body 10 will function as a molded interconnect device (MID) in which the predetermined circuit patterns (wiring) 14A and 14B are provided from the mounting surface of the LED chip 11 to the side surfaces of the body portion 12.

Moreover, a conical surface of the conical hollow in which the head is cut off functions as a reflecting plate 15 that reflects light radiated from the LED chip 11. By forming the reflecting plate 15 into such a conical surface, the LED package can realize high reliability and high light extraction efficiency. Note that, in the package body 10, a metal film having high reflectivity may be formed on a portion of the reflecting plate 15. In such a way, in the LED package, higher reliability and higher light extraction efficiency can be realized.

In the LED package as described above, such a molded circuit board in which the mounting surface of the LED chip 11 and the reflecting plate 15 are integrated together can be formed easily by a thin film outline removing method. This thin film outline removing method is composed of the following processes.

First, in the thin film outline removing method, a heating treatment process is executed, the sintered body is subjected to heat treatment under conditions where a temperature is 1000°C and a holding time is one hour, and a surface of the sintered body is cleaned.

Subsequently, in the thin film outline removing method, a conductive thin film forming process is executed. This process is a process for forming a conductive thin film on a surface of a board material by a physical evaporation method using a vacuum evaporation device, a DC magnetron sputtering device and the like, by a wet method such as electroless plating, and by the like. Specifically, the board material is set in a chamber of a plasma processing device, an inside of the chamber is decompressed to approximately 10⁻⁴ Pa, and thereafter, the sintered body is preheated at a temperature of 100 to 200°C for three minutes. Thereafter, gas of nitrogen, argon or the like is flown into the chamber, and a pressure of the gas in the chamber is controlled to approximately 10 Pa. Then, a high frequency voltage (RF: 13.56 MHz) of which power is 100 to 1000W is applied between electrodes for 10 to 300 seconds, whereby plasma processing is performed. Subsequently, a pressure in the chamber is controlled to 10⁻⁴ Pa or less, and argon gas is introduced into the chamber in this state so that a pressure thereof can become approximately 0.6 Pa, and thereafter, a direct current voltage of 300 to 600V is further applied between the electrodes, whereby a metal target is bombarded, and a conductive thin film of which film thickness is in a range from 100 to 1000 nm is formed on a surface of the sintered body. Note that copper, nickel, chromium, titanium and the like are used as the conductive material.

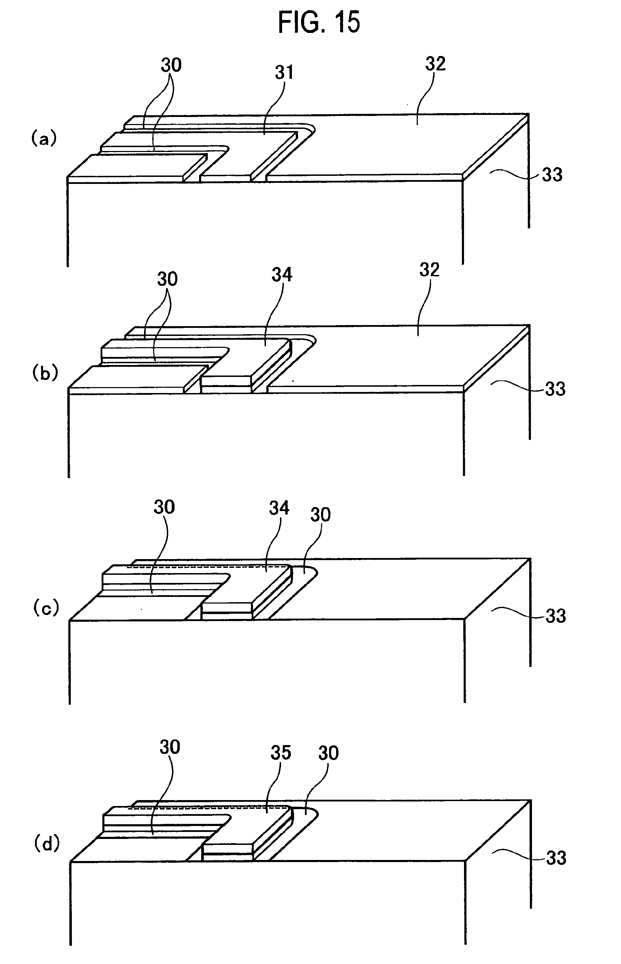

Subsequently, in the thin film outline removing method, a circuit pattern forming process is executed, and for example as shown in FIG. 15(a), a laser is scanned along an outline of the circuit pattern by using a third harmonic generation (THG-YAG laser) of a YAG laser in the atmosphere, and a thin film removal portion 30 is formed, which is obtained by removing only the thin film of an outline portion of a circuit pattern 31 from a conductive film 32 formed on an alumina substrate 33.

Subsequently, in the thin film outline removing method, a plating process is executed, and for example as shown in FIG. 15(b), copper plating 34 is formed only on an electric circuit portion on the surface of the sintered body by electrolytic plating, and is thereby thickened, and a copper film of which thickness is 5 to 15 µm is formed. Thereafter, for example as shown in FIG. 15(c), the entire surface of the sintered body is etched, whereby the conductive thin film 32 remaining on a non-electric circuit portion is removed completely by etching. At this time, the copper plating 34 is formed thicker than the conductive thin film 32, and accordingly, remains. Then, for example as shown in FIG. 15(d), nickel plating or gold plating 35 is formed on the electric circuit portion by electric plating.

The LED package can be easily formed by the thin film outline removing method as described above. Note that, in the case of manufacturing the LED package by the thin film outline removing method, after similarly performing the processes up to the copper plating, the etching and the nickel plating, which are described above, gold plating just needs to be formed on the electric circuit portion by supplying electric power only to the electric circuit portion, and for example, silver plating just needs to be formed on the reflecting plate 15 by supplying the electric power only to the reflecting plate 15.

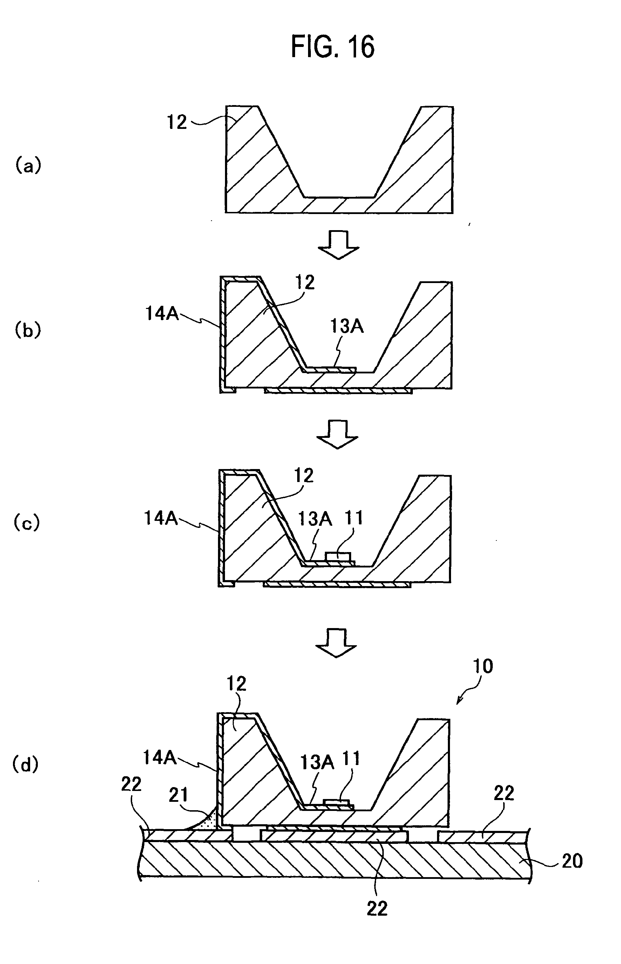

As shown in FIG. 16(d), the LED package formed as described above is mounted on the mounting board 20 on which the predetermined circuit pattern 22 is formed while interposing the solder 21 therebetween.

The LED package as described above can be formed in the following manner. Specifically, in manufacturing the LED package, for example as shown in FIG. 16(a), the sintered body (body portion 12) is formed. Subsequently, in manufacturing the LED package, for example as shown in FIG. 16(b), the circuit patterns 14A and 14B are formed on the surface of the sintered body by the above-mentioned thin film outline removing method, and as shown in FIG. 16(c), the LED chip 11 is mounted on the LED chip mounting portion 13A and 13B formed on the LED chip mounting surface. At this time, the circuit patterns 14A and 14B may be formed on the two adjacent side surfaces among the four side surfaces of the body portion 12 as shown in FIG. 13, or may be formed only on the single side surface thereamong as shown in FIG. 14. Thereafter, as shown in FIG. 16(d), the body portion 12 is arranged on a predetermined position so that the circuit patterns 14A and 14B on the body portion 12 and the circuit pattern 22 on the mounting board 20 can be brought into contact with each other. Thereafter, the circuit patterns 14A and 14B and the circuit pattern 22 are soldered to each other by the solder 21, whereby the body portion 12 is fixed onto the mounting board 20.

As described above, in accordance with the package body 10 to which the present invention is applied, the plurality of circuit patterns 14A and 14B are arranged close to each other, whereby portions other than the plurality of circuit patterns 14A and 14B are not fixed. In the package body 10 as described above, a distance between the solder 21 of the circuit pattern 14A and the solder 21 of the circuit pattern 14B is short, and even if the body portion 12 expands, the absolute expansion amount of the body portion 12 between the solder 21 of the circuit pattern 14A and the solder 21 of the circuit pattern 14B can be reduced since the distance concerned is short. In such a way, the crack in the solder 21 can be prevented, and the conduction failure can be prevented.

Note that the above-mentioned embodiment is merely an example of the present invention. Accordingly, the present invention is not limited to the above-mentioned embodiment, and it is a matter of course that it is possible to add various alterations to the embodiment according to needs within the scope without departing from the technical concept according to the present invention.

### (Third Embodiment)

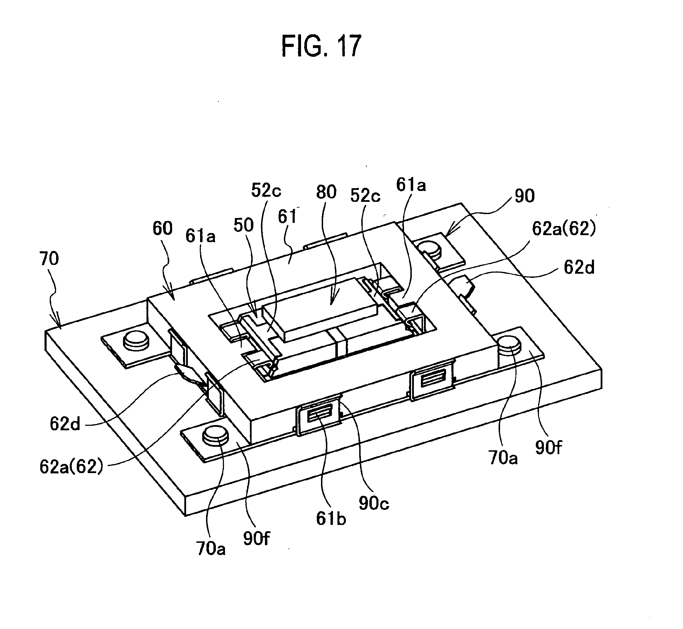

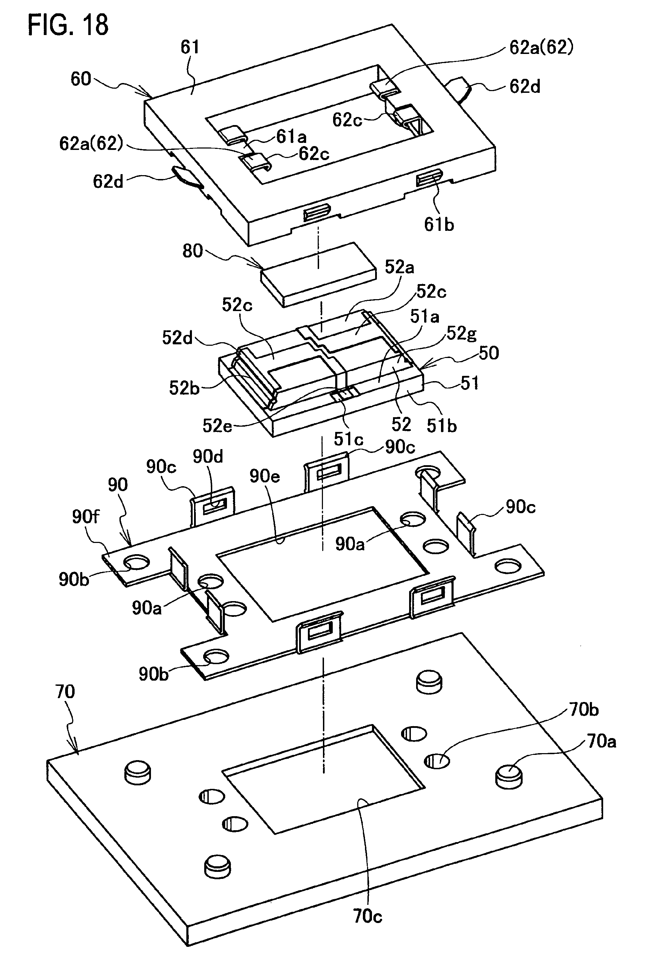

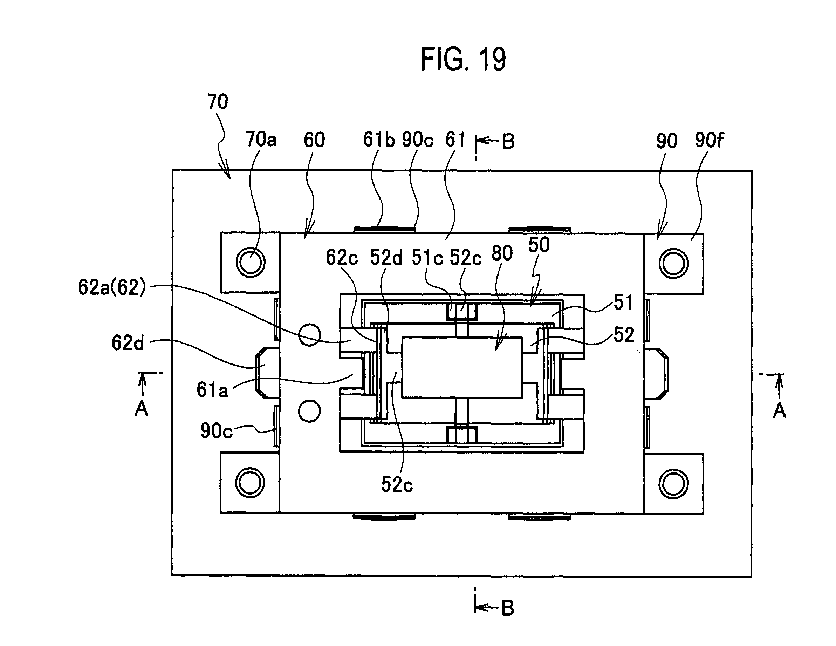

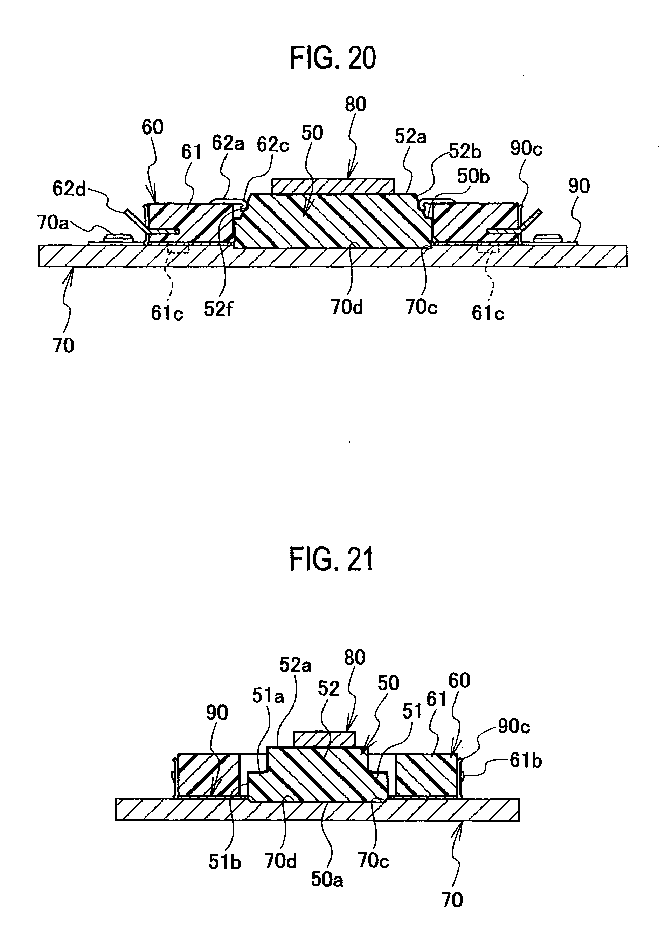

FIG. 17 is a perspective view of a molded circuit component according to this embodiment, FIG. 18 is an exploded perspective view of the attachment structure of the molded circuit component, FIG. 19 is a plan view of the attachment structure of the molded circuit component, FIG. 20 is a cross-sectional view along a line A-A of FIG. 19, and a FIG. 21 is a cross-sectional view along a line B-B of FIG. 19. Note that, in the following, a structure is illustrated, which uses an LED chip as an electronic component, and attaches the molded circuit component to a heat radiation plate.

The attachment structure of the molded circuit component according to this embodiment includes: a substantially rectangular parallelepiped LED chip 80 in which positive and negative electrodes (not shown) are formed on a lower surface; a molded circuit component 50 on which the LED chip 80 concerned is mounted; a socket 60 that houses the molded circuit component 50 therein; a holding fixture 90 that reinforces the socket 60; and a heat radiation plate 70 that radiates heat generated from the LED chip 80.

The molded circuit component 50 is formed of a resin material such as polyphenylene sulfide (PPS), polyetheretherketone (PEEK) and polyphthalamid, and has insulating properties. Note that the molded circuit component 50 just needs to have the insulating properties, and a ceramic material such as alumina, aluminum nitride and silicon carbide is also usable besides the resin-made material. Moreover, a metal core substrate is also usable, in which copper, aluminum or the like is molded into a predetermined shape and is coated with an insulating material.

In this embodiment, the molded circuit component 50 is formed into a shape including: a substantially rectangular parallelepiped lower stage portion 51; and an upper stage portion 52 having a rectangular shape a little smaller than the lower stage portion 51 when viewed from above, and having a substantially trapezoidal shape when viewed from side.

Specifically, the molded circuit component 50 has a shape in which the upper stage portion 52 having a bottom surface a little smaller than an upper surface of the substantially rectangular parallelepiped lower stage portion 51 is mounted on the lower stage portion 51, and as shown in FIG. 19, a substantially frame-like flat surface 51a is formed on the upper surface of the lower stage portion 51. Then, groove portions 51c and 51c are individually provided on substantial center portions in a longitudinal direction (right and left direction in FIG. 19) on both sides in a lateral direction (up and down direction in FIG. 19) of the flat surface (surface of the molded circuit component 50) 51a. Moreover, as shown in FIG. 21, in the lower stage portion 51, both ends in the lateral direction of a lower surface thereof are chamfered into a tapered shape.

Then, inclined surfaces 52b and 52b are individually provided on both side portions in the longitudinal direction of the upper stage portion 52, and on these inclined surfaces 52b and 52b, substantially V-shaped grooves are individually formed along the lateral direction.

Specifically, in this embodiment, notched recessed portions 50b are provided on both side portions in the longitudinal direction of the molded circuit component 50, and inner surfaces of the notched recessed portions 50b are formed of the inclined surfaces 52b of the upper stage portion 52, and the flat surface 51a of the lower stage portion 51.

Moreover, on an upper surface portion (surface of the molded circuit component 50) 52a of the upper stage portion 52, the inclined surfaces (surface of the molded circuit component 50) 52b thereof and side surface portions (surface of the molded circuit component 50) 52g thereof, as shown in FIG. 18, a pair of circuit patterns 52c and 52c are formed.

In this embodiment, on the inclined surfaces 52b and 52b of the upper stage portion 52, contact panel portions (terminal portions) 52d and 52d, each of which is a part of each of the circuit patterns 52c and 52c, are provided.

Moreover, in this embodiment, each of the contact panel portions 52d is formed so as to correspond to a shape of the inclined surfaces 52b, and on the contact panel portions 52d, substantially V-shaped notch portions 52f are provided along the lateral direction. Then, bent portions 62c of lead frames (first contact springs) 62a to be descried later are brought into contact with an inside of each of the notch portions 52f at two spots.

Furthermore, in this embodiment, as shown in FIG. 18, in one of the circuit patterns 52c (for example, left circuit pattern 52c in FIG. 18), the contact panel portion 52d is provided from the inclined surface 52b to a tip end in the longitudinal direction of the upper surface portion 52a, and is linearly extended from the contact panel portion 52d toward a center portion of the upper surface portion 52a. Then, the circuit pattern 52c is extended toward the groove portion 51c of the flat surface 51a so as to be bent in the lateral direction in the vicinity of the center portion of the upper surface portion 52a and to pass through the side surface portion 52g on the lateral direction side, and an end portion 52e of the circuit pattern 52c is housed in the groove portion 51c. Note that the other circuit pattern 52c has the same shape as that of the one circuit pattern 52c, and is arranged at a position point-symmetric to the one circuit pattern 52c with respect to such a center point of the upper surface portion 52a. Then, the LED chip 80 is mounted and attached onto the molded circuit component 50 so that the positive and negative electrodes of the LED chip 80 concerned can be individually brought into contact with the respective circuit patterns 52c and 52c, whereby the LED chip 80 is electrically connected to the molded circuit component 50.

The socket 60 includes a frame portion 61 made of synthetic resin, and a contact spring portion 62 made of metal.

The frame portion 61 has a substantial frame shape, and in a center portion thereof, the above-described molded circuit component 50 is housed. Moreover, on longitudinal direction sides of inner side surfaces of the frame portion 61, protruding portions 61a and 61a protruding inward are provided on substantial center portions in the lateral direction. These protruding portions 61a and 61a abut against side surface portions 51b and 51b on longitudinal direction sides of the lower stage portion 51, whereby the molded circuit component 50 is positioned with respect to the frame portion 61 at the time of housing the molded circuit component 50 in the frame portion 61.

Moreover, on outer side surfaces of the frame portion 61, fitting protruding portions 61b for attaching the socket 60 to the holding fixture 90 to be described later are provided. In this embodiment, the fitting protruding portions 61b are provided at two spots on each of both surfaces in the lateral direction.

Then, in the vicinities of four corners on inner peripheral sides of a lower surface portion of the frame portion 61, as shown in FIG. 20, attaching protruding portions 61c having a substantially cylindrical shape are provided. Then, these attaching protruding portions 61c are inserted through attachment holes 70b provided in the heat radiation plate 70 to be described later, whereby the socket 60 is attached to the heat radiation plate 70.

The contact spring portion 62 holds the molded circuit component 50. In this embodiment, a pair of lead frames (first contact springs) 62a and 62a are provided as the contact spring portion 62. In each of the lead frames (first contact springs) 62a, bent portions 62c formed by bending one of end portions thereof into a substantial hook shape are provided, and an external connection portion 62d is provided on the other end portion. Moreover, in this embodiment, the one end portion of the lead frame 62a is bifurcated, and on such bifurcated tips, the bent portions 62c are provided. Then, the pair of lead frames 62a and 62a are individually arranged on longitudinal direction sides of the frame portion 61 so that the bent portions 62c can protrude to insides of the inner side surfaces of the frame portion 61, and that the external connection portions 62d can protrude to outsides of the outer side surfaces of the frame portion 61. In this embodiment, the pair of lead frames 62a and 62a are molded integrally with the frame portion 61 by insert molding. Then, the external connection portions 62d are connected, for example, to connectors (not shown), and are electrically connected to the outside.

The heat radiation plate 70 has a plate shape. In the heat radiation plate 70, protruding portions 70a for attaching the holding fixture 90 thereto are formed, and on inner peripheral sides of the protruding portions 70a, attachment holes 70b through which the attaching protruding portions 61c of the frame portion 60 are inserted are formed. Moreover, in a center portion of the heat radiation plate 70, a fitting recessed portion 70c that corresponds to a shape of a lower surface shape of the lower stage portion 51 of the molded circuit component 50 is provided, and the lower stage portion 51 of the molded circuit component 50 is fitted to the fitting recessed portion 70c.

In the holding fixture 90, insertion holes 90e for inserting the molded circuit component 50 through a center portion thereof are provided, and the holding fixture 90 has a substantial frame shape corresponding to a shape of the frame portion 61. Then, on four corners of the holding fixture 90, attachment portions 90f for attaching the heat radiation plate 70 to the holding fixture 90 are individually protruded, and in the respective attachment portions 90f, attachment holes 90b corresponding to the protruding portions 70a provided on the heat radiation plate 70 are individually provided.

Moreover, in a peripheral edge portion of the insertion hole 90e, insertion holes 90a for inserting the attaching protruding portions 61c therethrough are formed.

Then, on an outer periphery of the holding fixture 90, erected pieces 90c for fitting and fixing the socket 60 to the holding fixture 90 are provided. In this embodiment, the erected pieces 90c are provided at two spots on each side of the outer periphery of the holding fixture 90. Moreover, in the erected pieces 90c on lateral direction sides of the holding fixture 90, fitting holes 90d which fit to the fitting protruding portions 61b are provided.

Next, a description will be made of an attachment method of the molded circuit component to the heat radiation plate.

First, the protruding portions 70a of the heat radiation plate 70 are inserted into the insertion holes 90a of the attachment portions 90f provided on the holding fixture 90, and the holding fixture 90 is attached onto the heat radiation plate 70. In this embodiment, the protruding portions 70a inserted into the insertion holes 90a are crimped, whereby the holding fixture 90 is attached onto the heat radiation plate 70. Note that such crimp fixing may be performed after the molded circuit component 50 and the socket 60 are attached onto the holding fixture 90.

Next, the molded circuit component 50 that mounts the LED chip 80 on the surface thereof is attached to the heat radiation plate 70 so that a lower surface portion 50a of the molded circuit component 50 can be allowed to abut against a surface portion of the heat radiation plate 70. Specifically, the lower surface portion of the lower stage portion 51 of the molded circuit component 50 is inserted through the insertion hole 90e of the holding fixture 90, and is fitted to the fitting recessed portion 70c. In such a way, the lower surface portion 50a of the molded circuit component 50 and a bottom surface 70d of the fitting recessed portion 70c are allowed to abut against each other. Note that, in this embodiment, the lower surface portion (lower surface portion 50a of the molded circuit component 50) of the lower stage portion 51 is chamfered into the tapered shape, and accordingly, it becomes easy to fit the molded circuit component 50 into the fitting recessed portion 70c of the heat radiation plate 70.

Finally, the fitting protruding portions 61b and the fitting holes 90d are fitted to each other, whereby the socket 60 is fitted and fixed to the holding fixture 90, and the bent portions 62c of each of the lead frames 62a are brought into contact at two spots with each of the notch portions 52f of the contact panel portions 52d provided on the inclined surfaces 52b of the molded circuit component 50. In such a way, the molded circuit component 50 and the socket 60 are electrically connected to each other, and the molded circuit component 50 is attached to the heat radiation plate 70.

In accordance with this embodiment described above, the notched recessed portions 50b are provided by cutting off both side portions in the longitudinal direction of the molded circuit component 50, the inclined surfaces 52b and 52b as the inner surfaces of the notched recessed portions 50b are provided on the molded circuit component 50, the contact panel portions 52d and 52d, each of which is a part of each of the pair of circuit patterns 52c, are individually provided on the inclined surfaces 52b and 52b, and the lead frames 62a and 62a provided on the socket 60 are brought into contact with the contact panel portions 52d and 52d concerned. Accordingly, a width of the socket 60 can be narrowed. As a result, miniaturization of the attachment structure of the molded circuit component 50 can be achieved. Moreover, the lead frames 62a and 62a individually press the inclined surfaces 52b and 52b, whereby the molded circuit component 50 is held, and accordingly, the lead frames 62a and the contact panel portions 52d can be suppressed from causing a contact failure therebetween.

Moreover, in accordance with this embodiment, the hook-like bent portions 62c brought into contact with the contact panel portions 52d are provided on the lead frame 62a, and the substantially V-shaped notch portions 52f are provided on the contact panel portions 52d, and then the bent portions 62c are brought into contact at two spots with the inside of each of the notch portions 52f. In such a way, the lead frames 62a and the contact panel portions 52d can be suppressed more from relatively moving to each other, and a situation where the lead frames 62a and the contact panel portions 52d do not contact each other anymore to cause the conduction failure therebetween can be suppressed.

Furthermore, in accordance with this embodiment, the protruding portions 61a which support the molded circuit component 50 are provided on the socket 60, whereby the molded circuit component 50 can be supported more surely. As a result, such relative movement of the socket 60 and the molded circuit component 50 can be suppressed more. Moreover, the molded circuit component 50 is positioned by the protruding portions 61a, and accordingly, the molded circuit component 50 can be attached to a predetermined position with accuracy.

Moreover, in accordance with this embodiment, the lower surface portion of the molded circuit component 50 is allowed to abut against the heat radiation plate 70, whereby the heat generated by the LED chip 80 can be radiated from the heat radiation plate 70.

Furthermore, in accordance with this embodiment, the holding fixture 90 that holds the socket 60 is provided, whereby the socket 60 is reinforced by the holding fixture 90, and strength of the socket 60 can be enhanced. Accordingly, thinning of the socket 60 can be achieved.

Next, a description will be made of a modification example of this embodiment.

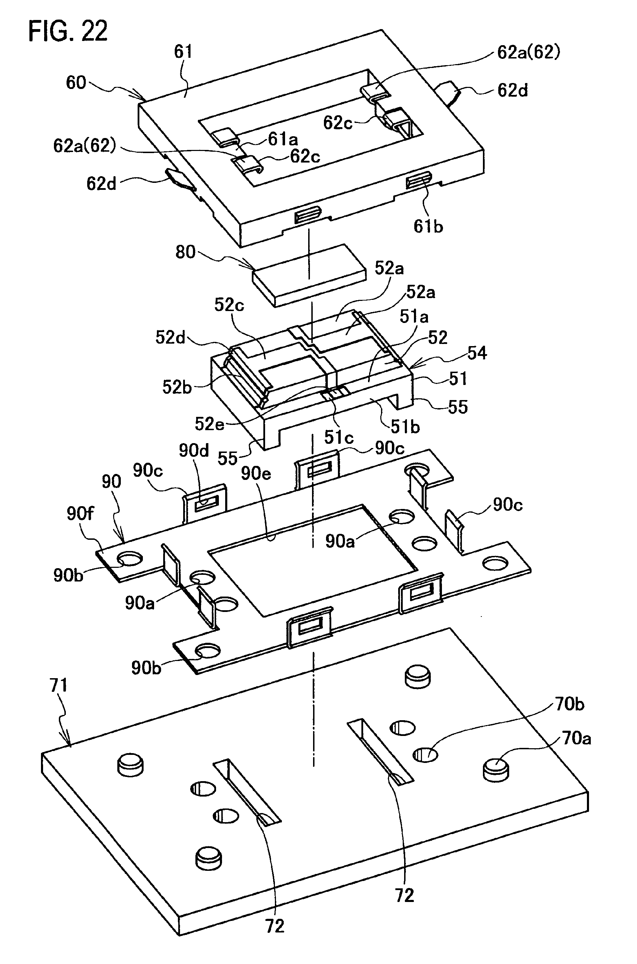

FIG. 22 is an exploded perspective view of an attachment structure of a molded circuit component according to the modification example of this embodiment. Note that the attachment structure of the molded circuit component according to the modification example of this embodiment includes similar constituents to those of the attachment structure of the molded circuit component according to the above-described third embodiment. Hence, common reference numerals are assigned to these similar constituents, and a duplicate description will be omitted.

In this modification example, protruding portions 55 and recessed portions 72, which fit to each other, are provided on a molded circuit component 54 and a heat radiation plate 71, respectively. Specifically, a pair of the protruding portions 55 and 55 are provided on both end portions in a longitudinal direction of a lower stage portion 51 of the molded circuit component 54, and the recessed portions 72 and 72 which fit the pair of protruding portions 55 and 55 thereto are provided on the heat radiation plate 71. At this time, it is suitable that a depth of the recessed portions 72 and 72 be set equivalent to a thickness of the protruding portions 55 and 55 or be deepened more than the thickness of the protruding portions 55 and 55 so that a lower surface of the molded circuit component 54 can abut against an upper surface of the heat radiation plate 71.

Other structures are basically the same as those in the above-described third embodiment.

Also in accordance with this modification example described above, similar effects to those in the above-described third embodiment can be obtained.

Moreover, in accordance with this modification example, the protruding portions 55 and the recessed portions 72, which fit to each other, are provided on the molded circuit component 54 and the heat radiation plate 71, respectively. In such a way, it can be facilitated to attach the molded circuit component 54 to the heat radiation plate 71, and in addition, the molded circuit component 54 is positioned, and the molded circuit component 54 can be attached to a predetermined position with accuracy.

### (Fourth Embodiment)

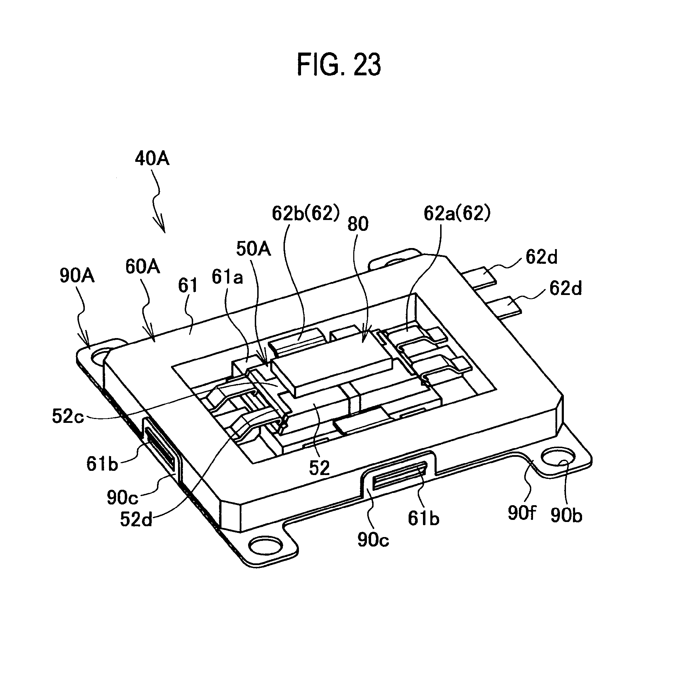

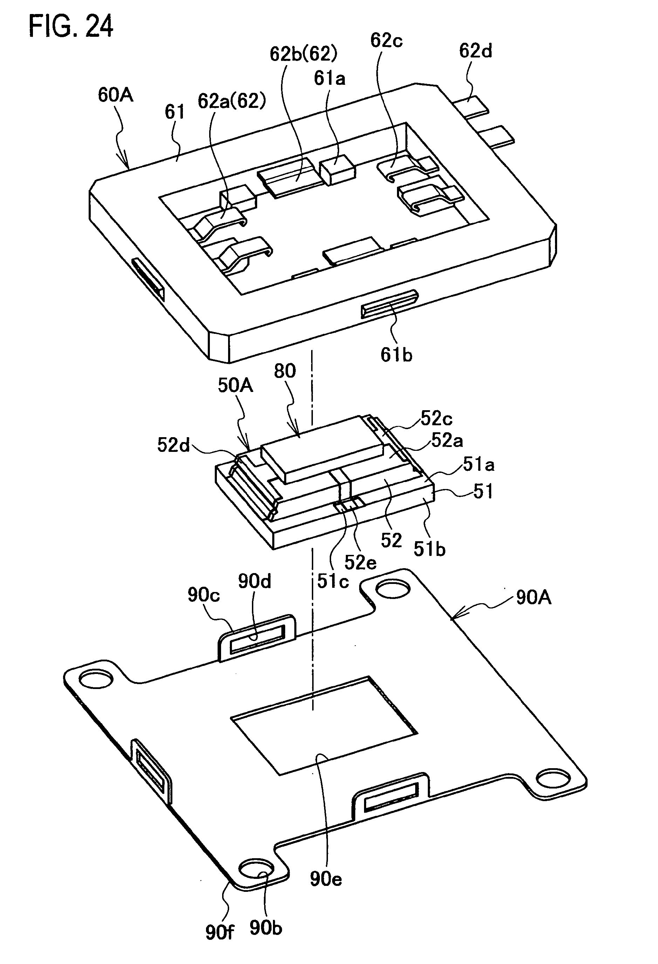

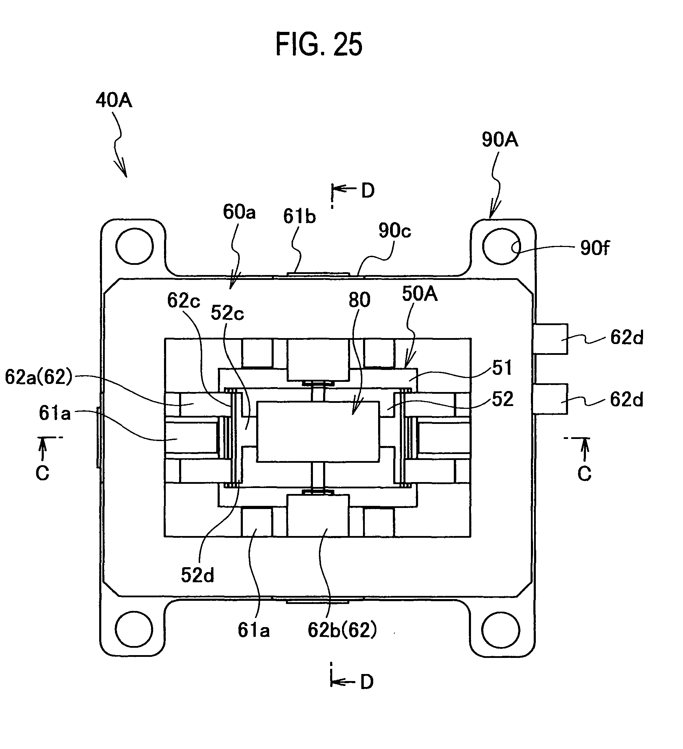

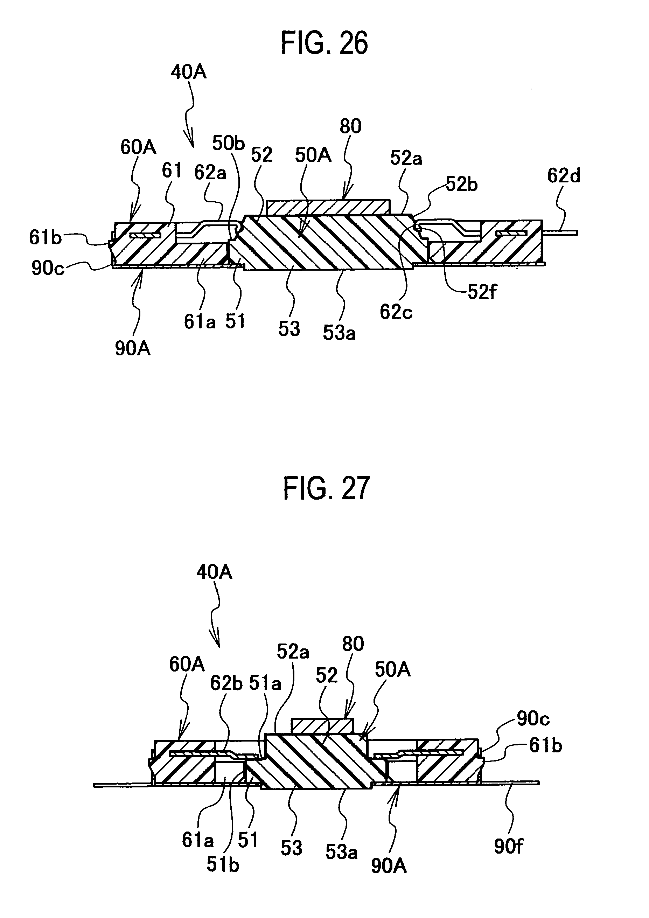

FIG. 23 is a perspective view of an attachment structure of a molded circuit component according to this embodiment, FIG. 24 is an exploded perspective view of the attachment structure of the molded circuit component, FIG. 25 is a plan view of the attachment structure of the molded circuit component, FIG. 26 is a cross-sectional view along a line C-C of FIG. 25, and FIG. 27 is a cross-sectional view along a line D-D of FIG. 25. Note that the attachment structure of the molded circuit component according to this embodiment includes similar constituents to those of the attachment structure of the molded circuit component according to the above-mentioned third embodiment. Hence, common reference numerals are assigned to these similar constituents, and a duplicate description will be omitted.

In the attachment structure of the molded circuit component according to this embodiment, a molded circuit component 50A, a socket 60A and a holding fixture 90A are sub-assembled as shown in FIG. 23, whereby a molded circuit component attachment module 40A is formed. Then, this molded circuit component attachment module 40A is fixed, for example, to the heat radiation plate 70 illustrated in the above-mentioned third embodiment.

In this embodiment, in the molded circuit component 50A, on a lower surface of a lower stage portion 51 thereof, a substantially rectangular parallelepiped protruding portion 53 a little smaller than the lower stage portion 51 concerned is provided.

Moreover, in the socket 60A, protruding portions 61a protruding inward are provided also on inner side surfaces on a lateral direction side of a frame portion 61, and as a contact frame portion 62, a pair of lead frames 62a and 62a and a pair of holding contact springs (second contact springs) 62b and 62b are formed integrally with the frame portion 61. Then, external connection portions 62d and 62d of the pair of lead frames 62a and 62a protrude in the same direction.

As shown in FIG. 27, the pair of holding contact springs 62b and 62b are bent in a crank shape, and are provided so as to protrude inward from the inner side surfaces on the lateral direction side of the frame portion 61.

In a similar way to the above-mentioned third embodiment, in the holding fixture 90A, an insertion hole 90e is provided in a center portion thereof. However, in this embodiment, this insertion hole 90e is set to have such a size that enables the protruding portion 53 of the molded circuit component 50A to be inserted therethrough, but does not enable the lower stage portion 51 of the molded circuit component 50A to be inserted therethrough. In short, at the time of forming the molded circuit component attachment module 40A, the lower surface portion of the lower stage portion 51 is allowed to abut against an upper surface of the holding fixture 90A. Moreover, in this embodiment, a lower surface portion 53a of the protruding portion 53 protrudes downward a little from a lower surface of the holding fixture 90A.

Moreover, in this embodiment, the fitting protruding portions 61b and the erected pieces 90c are provided in three directions other than a direction in which the external connection portions 62d and 62d are protruded.

The molded circuit component 50A, the socket 60A and the holding fixture 90A, which have configurations as described above, are sub-assembled, whereby the molded circuit component attachment module 40A is formed.

Specifically, the protruding portion 53 of the molded circuit component 50A that mounts the LED chip 80 on a surface thereof is inserted through the insertion hole 90e of the holding fixture 90A, and the molded circuit component 50A is mounted on the holding fixture 90A so that the lower surface portion of the lower stage portion 51 can abut against the upper surface of the holding fixture 90A. Then, the fitting protruding portions 61b and fitting holes 90d provided in the erected pieces 90c are fitted to each other, and the socket 60A is fitted and fixed to the holding fixture 90A.

At this time, bent portions 62c of each of the lead frames 62a are brought into contact at two spots with each of insides of notch portions 52f of contact panel portions 52d provided on inclined surfaces 52b of the molded circuit component 50. In such a way, the molded circuit component 50 and the socket 60 are electrically connected to each other. Moreover, the molded circuit component 50A is held by the socket 60A and the holding fixture 90A in such a manner that the lead frames 62a and 62a press the inclined surfaces 52b and 52b, and that the holding contact springs 62b and 62b press a flat surface 51a of the lower stage portion 51 of the molded circuit component 50A. In this embodiment, the holding contact springs 62b and 62b press regions in which groove portions 51c are formed. Here, in the groove portions 51c, end portions 52e of circuit patterns 52c are housed.

In such a way, the molded circuit component attachment module 40A is formed, and in a similar way to the above-mentioned third embodiment, the protruding portions 70a provided on the heat radiation plate 70 are inserted through the attachment holes 90b provided in the attachment portions 90f of the holding fixture 90A, and the protruding portions 70a are crimped, whereby the molded circuit component attachment module 40A is attached to the heat radiation plate 70.

Also in accordance with this embodiment described above, similar effects to those in the above-mentioned third embodiment can be obtained.

Moreover, in accordance with this embodiment, separately from the lead frames 62a and 62a, the holding contact springs 62b and 62b which hold the molded circuit component 50A are provided, and accordingly, the molded circuit component 50A can be held more surely. In addition, it becomes possible to hold the molded circuit component 50A even if pressing forces against the inclined surfaces 52b and 52b by the lead frames 62a and 62a are set low. As a result, the circuit patterns 52c and 52c can be suppressed from being peeled off by the pressing against the inclined surfaces 52b and 52b by the lead frames 62a and 62a, and a lifetime of the circuit patterns 52c can be enhanced.

Furthermore, in accordance with this embodiment, the holding contact springs 62b and 62b and the frame portion 61 are molded integrally with each other, whereby simplification of a manufacturing process of the attachment structure can be achieved, and in addition, reduction of the number of components thereof can be reduced, whereby the attachment structure can be manufactured advantageously in terms of cost.

Moreover, in accordance with this embodiment, the groove portions 51c are formed on the flat surface 51a of the lower stage portion 51 of the molded circuit component 50A, and the end portions 52e of the circuit patterns 52c are housed in the groove portions 51c. In such a way, even if regions on which the circuit patterns 52c are provided and regions pressed by the holding contact springs 62b and 62b overlap each other, the holding contact springs 62b and 62b are prevented from directly pressing against the circuit patterns 52c. Accordingly, the circuit patterns 52c can be suppressed from being peeled off.

Moreover, in accordance with this embodiment, the attachment portions 90f to the heat radiation plate 70 are provided in the holding fixture 90. Accordingly, the lead frames 62a and the contact panel portions 52d can be suppressed from causing the conduction failure therebetween at the time of attaching the molded circuit component 50A to the heat radiation plate 70, and the molded circuit component 50A can be attached to the heat radiation plate 70 without causing the conduction failure.

Furthermore, in accordance with this embodiment, the protruding portions 53 are provided on the lower surface portion of the molded circuit component 50A, and in addition, the insertion hole 90e is provided on the holding fixture 90A, and the protruding portion 53 is inserted through the insertion hole 90e. In such a way, at the time of attaching the molded circuit component 50A to the heat radiation plate 70, it becomes possible to attach the molded circuit component 50A to the heat radiation plate 70 not only from above but also transversely while moving the molded circuit component 50A along the surface of the heat radiation plate 70, whereby a degree of freedom in attaching the molded circuit component 50A to the heat radiation plate 70 can be enhanced.

### (Fifth Embodiment)

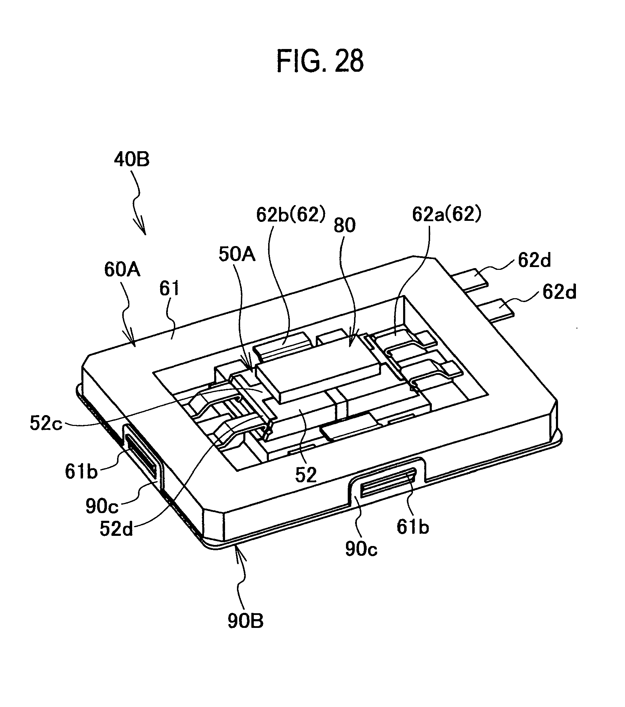

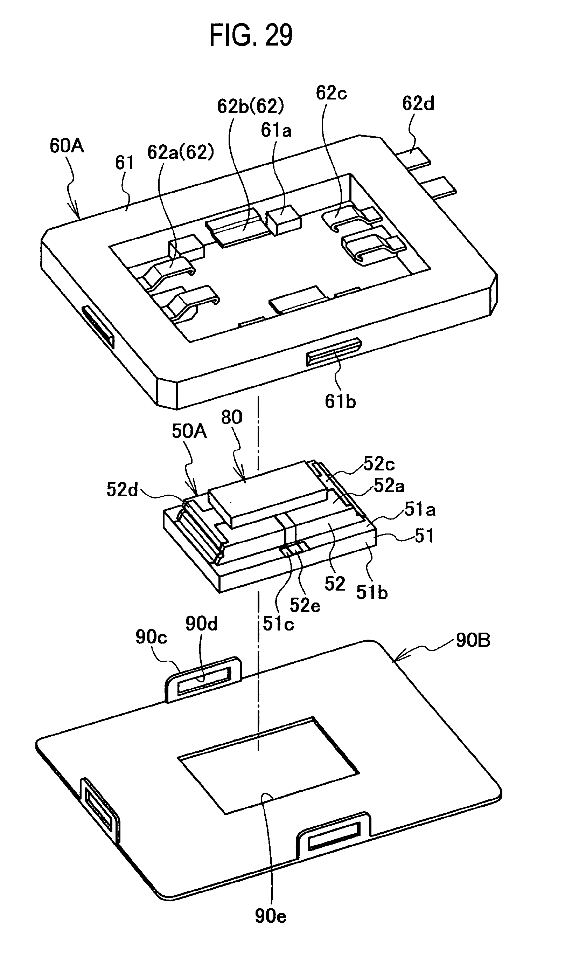

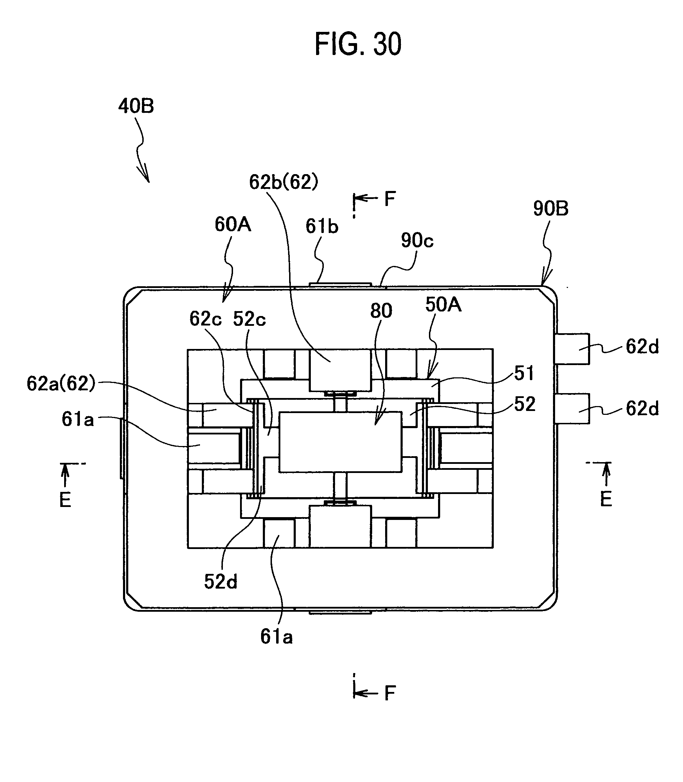

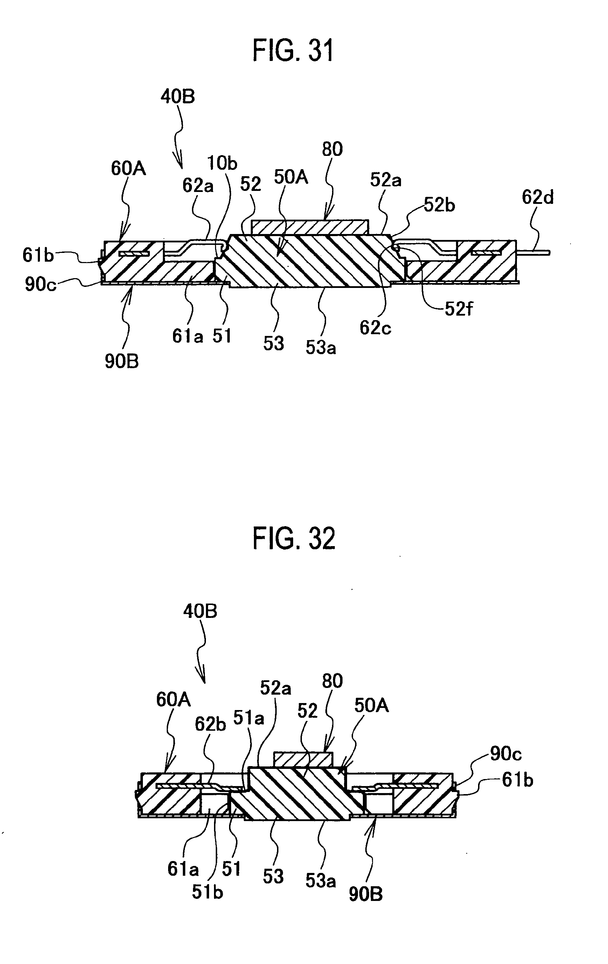

FIG. 28 is an exterior perspective view of an attachment structure of a molded circuit component according to this embodiment, FIG. 29 is an exploded perspective view of the attachment structure of the molded circuit component, FIG. 30 is a plan view of the attachment structure of the molded circuit component, FIG. 31 is a cross-sectional view along a line E-E of FIG. 30, and FIG. 32 is a cross-sectional view along a line F-F of FIG. 30. Note that the attachment structure of the molded circuit component according to this embodiment includes similar constituents to those of the attachment structure of the molded circuit component according to the above-mentioned fourth embodiment. Hence, common reference numerals are assigned to these similar constituents, and a duplicate description will be omitted.

The attachment structure of the molded circuit component according to this embodiment is different from that according to the above-mentioned fourth embodiment in that the attachment portions to the heat radiation plate are not provided in a holding fixture 90B, and other configurations are basically similar to those of the above-mentioned fourth embodiment.

Specifically, in this embodiment, the molded circuit component 50A, the socket 60A and the holding fixture 90B are sub-assembled as shown in FIG. 28, whereby a molded circuit component attachment module 40B is formed.

Then, for example, a pair of substantially L-shaped guide portions (not shown) are provided on the heat radiation plate, and this molded circuit component attachment module 40B is inserted between the guide portions while allowing the guide portions concerned to guide side surfaces and upper surface of the socket 60A, whereby the molded circuit component attachment module 40B is fixed to the heat radiation plate. Note that another configuration may be adopted, in which the guide portions are provided on members other than the heat radiation plate, and the molded circuit component attachment module 40B is fixed to the heat radiation plate while allowing the guide portions concerned to guide the molded circuit component attachment module 40B concerned.

Also in accordance with this embodiment described above, similar effects to those in the above-mentioned third and fourth embodiments can be obtained.

The description has been made above of the preferred embodiments of the attachment structure of the molded circuit component according to the present invention; however, the present invention is not limited to the above-mentioned embodiments, and a variety of embodiments can be adopted within the scope without departing from the gist thereof.

For example, for attaching the holding fixture to the heat radiation plate, not the crimp fixing but screwing may be adopted.

Moreover, a semiconductor may be used as the electronic component, and one on which a variety of circuit patterns are formed may be used as the molded circuit component. Note that, according to the usage purpose, it is possible to appropriately set the type of the electronic component, the shape of the circuit pattern, and the like.

Furthermore, the molded circuit component may be attached to a member other than the heat radiation plate.

Moreover, though the bent portions are formed by being bent into the substantial hook shape, the shape of the bent portions is not limited to this, and for example, the bent portions can be formed by being bent into a substantial U-shape. As described above, it is possible to form the bent portions into a variety of shapes.

Furthermore, though one having the shape on which the inclined surfaces are formed is used as the molded circuit component, the shape of the molded circuit component is not limited to this. For example, for the molded circuit component, a structure may be adopted, in which the substantially rectangular parallelepiped upper stage portion a little smaller than the substantially rectangular parallelepiped lower stage portion is mounted on the upper surface thereof, terminal portions are provided on side surfaces of the upper stage portion, and the bent portions are brought into contact with the terminal portions.

### INDUSTRIAL APPLICABILITY

In accordance with the present invention, the LED package can be obtained, which effectively relieves the stress generated owing to the difference thereof from the mounting board in linear expansion coefficient, thereby prevents the breakage of the solder, and can prevent the conduction failure.

Moreover, the attachment structure of the molded circuit component can be obtained, which can suppress the conduction failure, and can achieve the miniaturization thereof.

## Claims

1. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein the plurality of elastic bodies hold a position of the molded interconnect device with respect to the mounting board by elastic forces given to an inner surface side of the molded interconnect device from a plurality of outer side surfaces thereof opposite to each other.

2. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein the plurality of elastic bodies hold a position of the molded interconnect device with respect to the mounting board by elastic force given from an upper surface of the molded interconnect device to a lower surface thereof.

3. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein, in the molded interconnect device, recessed portions are formed on a plurality of outer side surfaces thereof opposite to each other, and
the plurality of elastic bodies hold a position of the molded interconnect device with respect to the mounting board by elastic forces given to an inner surface side of the molded interconnect device from the recessed portions thereof.

4. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein, in the molded interconnect device, notched recessed portions are formed on lower ends of a plurality of outer side surfaces thereof opposite to each other, and
the plurality of elastic bodies are housed in insides of the recessed portions formed on the molded interconnect device, the insides being also insides of an outer shape of the molded interconnect device, and hold a position of the molded interconnect device with respect to the mounting board by elastic forces given to an inner surface side of the molded interconnect device from the recessed portions thereof.

5. The LED package according to any one of claims 1 to 4, wherein pad portions, each of which is a part of a circuit pattern and has the elastic body attached thereto by solder, are formed on the mounting board, and the elastic bodies are arranged on the pad portions onto which the solder is attached, and are fixed thereto by the solder.

6. The LED package according to any one of claims 1 to 4,
wherein the elastic bodies are provided on a molded body molded into a shape of a frame,
the molded body is mounted on the mounting board by solder, and
the molded interconnect device is arranged in an inside of the frame of the molded body and is positioned with respect to the frame by the elastic forces of the elastic bodies.

7. An LED package comprising:
a molded interconnect device that has an LED chip mounted thereon, and is mounted on a mounting board electrically connected to the LED chip; and
a plurality of circuit patterns which are connected to the LED chip and a circuit pattern on the mounting board while interposing solder therebetween, and are formed along an outer wall of the molded interconnect device,
wherein the plurality of circuit patterns are individually formed on adjacent side surfaces among a plurality of side surfaces of the molded interconnect device.

8. An LED package comprising:
a molded interconnect device that has an LED chip mounted thereon, and is mounted on a mounting board electrically connected to the LED chip; and
a plurality of circuit patterns which are connected to the LED chip and a circuit pattern on the mounting board while interposing solder therebetween, and are formed along an outer wall of the molded interconnect device,
wherein the plurality of circuit patterns are individually formed on a single surface among a plurality of side surfaces of the molded interconnect device.

9. An attachment structure of a molded circuit component, including: a molded circuit component, on a surface of which circuit patterns electrically connecting an electronic component thereto are formed, the molded circuit component having the electronic component mounted thereon; and a socket having a frame portion that houses the molded circuit component therein, and a contact spring portion that holds the molded circuit component,
wherein, in the molded circuit component, notched recessed portions formed by cutting off side portions of the molded circuit component are provided, and terminal portions, each of which is a part of the circuit pattern, are provided on inner surfaces of the notched recessed portions, and
the contact spring portion includes first contact springs which contact the terminal portions, and hold the molded circuit component by pressing the inner surfaces of the notched recessed portions.

10. The attachment structure of a molded circuit component according to claim 9, wherein the contact spring portion includes second contact springs which hold the molded circuit component.

11. The attachment structure of a molded circuit component according to claim 10, wherein the second contact springs and the frame portion are molded integrally with each other.

12. The attachment structure of a molded circuit component according to any one of claims 9 to 11, wherein recessed portions are formed on at least a part of the molded circuit component, and the circuit patterns are formed in the recessed portions.

13. The attachment structure of a molded circuit component according to any one of claims 9 to 12, wherein the first contact springs include bent portions which abut against the terminal portions, and the terminal portions include notch portions, and bring the bent portions into contact with the notch portions at two spots.

14. The attachment structure of a molded circuit component according to any one of claims 9 to 13, wherein the socket includes protruding portions which support the molded circuit component.

15. The attachment structure of a molded circuit component according to any one of claims 9 to 14, wherein a lower surface portion of the molded circuit component is allowed to abut against a heat radiation plate.

16. The attachment structure of a molded circuit component according to claim 15, wherein a holding fixture that holds the socket is provided under the socket, and the lower surface portion of the molded circuit component is allowed to abut against the heat radiation plate while interposing the holding fixture therebetween.

17. The attachment structure of a molded circuit component according to claim 16, wherein protruding portions are formed on the lower surface portion of the molded circuit component, insertion holes are provided in the holding fixture, and the protruding portions are inserted through the insertion holes.

18. The attachment structure of a molded circuit component according to either one of claims 16 and 17, wherein the holding fixture includes attachment portions to the heat radiation plate.

19. The attachment structure of a molded circuit component according to claim 15, wherein protruding and recessed portions which fit to each other are provided on the molded circuit component and the heat radiation plate, respectively.

## Amended claims

### Amended claims under Art. 19.1 PCT

1. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein the plurality of elastic bodies hold a position of the molded interconnect device with respect to the mounting board by elastic forces given to an inner surface side of the molded interconnect device from a plurality of outer side surfaces thereof opposite to each other.

2. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein the plurality of elastic bodies hold a position of the molded interconnect device with respect to the mounting board by elastic force given from an upper surface of the molded interconnect device to a lower surface thereof.

3. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein, in the molded interconnect device, recessed portions are formed on a plurality of outer side surfaces thereof opposite to each other, and
the plurality of elastic bodies hold a position of the molded interconnect device with respect to the mounting board by elastic forces given to an inner surface side of the molded interconnect device from the recessed portions thereof.

4. An LED package comprising:
a molded interconnect device that has an LED chip mounted thereon, and is mounted on a mounting board electrically connected to the LED chip; and
a plurality of elastic bodies mounted on the mounting board while interposing solder therebetween,
wherein, in the molded interconnect device, notched recessed portions are formed on lower ends of a plurality of outer side surfaces thereof opposite to each other, and
the plurality of elastic bodies are housed in insides of the recessed portions formed on the molded interconnect device, the insides being also insides of an outer shape of the molded interconnect device, and hold a position of the molded interconnect device with respect to the mounting board by elastic forces given to an inner surface side of the molded interconnect device from the recessed portions thereof.

5. The LED package according to any one of claims 1 to 4, wherein pad portions, each of which is a part of a circuit pattern and has the elastic body attached thereto by solder, are formed on the mounting board, and the elastic bodies are arranged on the pad portions onto which the solder is attached, and are fixed thereto by the solder.

6. The LED package according to any one of claims 1 to 4,
wherein the elastic bodies are provided on a molded body molded into a shape of a frame,
the molded body is mounted on the mounting board by solder, and
the molded interconnect device is arranged in an inside of the frame of the molded body and is positioned with respect to the frame by the elastic forces of the elastic bodies.

7. An LED package comprising:
a molded interconnect device that has an LED chip mounted thereon, and is mounted on a mounting board electrically connected to the LED chip; and
a plurality of circuit patterns which are connected to the LED chip and a circuit pattern on the mounting board while interposing solder therebetween, and are formed along an outer wall of the molded interconnect device,
wherein the plurality of circuit patterns are individually formed on adjacent side surfaces among a plurality of side surfaces of the molded interconnect device.

8. An LED package comprising:
a molded interconnect device that has an LED chip mounted thereon, and is mounted on a mounting board electrically connected to the LED chip; and
a plurality of circuit patterns which are connected to the LED chip and a circuit pattern on the mounting board while interposing solder therebetween, and are formed along an outer wall of the molded interconnect device,
wherein the plurality of circuit patterns are individually formed on a single surface among a plurality of side surfaces of the molded interconnect device.

9. (amended) An attachment structure of a molded circuit component, including: a molded circuit component, on a surface of which circuit patterns electrically connecting an electronic component thereto are formed, the molded circuit component having the electronic component mounted thereon; and a socket having a frame portion that houses the molded circuit component therein, and a contact spring portion that holds the molded circuit component,
wherein, in the molded circuit component, a pair of notched recessed portions are provided on both side portions in at least one direction of the molded circuit component, and terminal portions, each of which is a part of the circuit pattern, are provided on inner surfaces of the pair of notched recessed portions, and
the contact spring portion includes a pair of first contact springs which are arranged on both side portions in the one direction of the molded circuit component so as to be opposite to each other while sandwiching the molded circuit component therebetween, and contact the terminal portions, and the pair of first contact springs hold the molded circuit component by individually pressing the inner surfaces of the pair of notched recessed portions toward a center side in the one direction of the molded circuit component.

10. (amended) The attachment structure of a molded circuit component according to claim 9,
wherein upper surface portions are provided on the inner surfaces of the notched recessed portions, and
the contact spring portion includes second contact springs which contact the upper surface portions of the notched recessed portions, and press the molded circuit component downward.

11. The attachment structure of a molded circuit component according to claim 10, wherein the second contact springs and the frame portion are molded integrally with each other.

12. The attachment structure of a molded circuit component according to any one of claims 9 to 11, wherein recessed portions are formed on at least a part of the molded circuit component, and the circuit patterns are formed in the recessed portions.

13. The attachment structure of a molded circuit component according to any one of claims 9 to 12, wherein the first contact springs include bent portions which abut against the terminal portions, and the terminal portions include notch portions, and bring the bent portions into contact with the notch portions at two spots.

14. (amended) The attachment structure of a molded circuit component according to any one of claims 9 to 13, wherein the socket includes a pair of protruding portions which are arranged so as to be opposite to each other while sandwiching the molded circuit component therebetween, and position the molded circuit component by individually abutting against side surfaces of the molded circuit component.

15. The attachment structure of a molded circuit component according to any one of claims 9 to 14, wherein a lower surface portion of the molded circuit component is allowed to abut against a heat radiation plate.

16. The attachment structure of a molded circuit component according to claim 15, wherein a holding fixture that holds the socket is provided under the socket, and the lower surface portion of the molded circuit component is allowed to abut against the heat radiation plate while interposing the holding fixture therebetween.

17. The attachment structure of a molded circuit component according to claim 16, wherein protruding portions are formed on the lower surface portion of the molded circuit component, insertion holes are provided in the holding fixture, and the protruding portions are inserted through the insertion holes.

18. The attachment structure of a molded circuit component according to either one of claims 16 and 17, wherein the holding fixture includes attachment portions to the heat radiation plate.

19. The attachment structure of a molded circuit component according to claim 15, wherein protruding and recessed portions which fit to each other are provided on the molded circuit component and the heat radiation plate, respectively.
